# EUROPEAN PATENT APPLICATION

(11) **EP 4 712 325 A1**
(43) Date of publication of application: **18.03.2026**
(21) Application number: 25812282.9
(22) Date of filing: 25.03.2025
(51) Int. Cl.: H02M 1/00, H02M 3/07, G06F 1/26

(54) **POWER SUPPLY CIRCUIT AND ELECTRONIC DEVICE INCLUDING SAME**

(30) Priority: 28.06.2024 KR 20240085817; 29.07.2024 KR 20240100583
(71) Applicant: Samsung Electronics Co., Ltd., Suwon-si, Gyeonggi-do 16677 (KR)
(72) Inventor: KANG, Hyunsang, Suwon-si, Gyeonggi-do 16677 (KR); NA, Hyoseok, Suwon-si, Gyeonggi-do 16677 (KR); MOON, Yohan, Suwon-si, Gyeonggi-do 16677 (KR); VAN, Juho, Suwon-si, Gyeonggi-do 16677 (KR)
(74) Representative: HGF
(86) International application number: PCT/KR2025/003829
(87) International publication number: WO 2026/005196

(57) **Abstract**

In embodiments, an electronic device is provided. The electronic device includes a processor including processing circuitry, a radio frequency (RF) transceiver, a first power supply circuitry for providing a power amplifier with a first supply voltage, a second power supply circuitry for providing the power amplifier or another power amplifier with a second supply voltage, a first power path connected to the first power supply circuitry, a second power path connected to the second power supply circuitry, wherein a third supply voltage is provided through the third power path, a first switching circuitry configured to connect or not connect the third power path to the first power path, a second switching circuitry configured to connect or not connect the third power path to the second power path, and a radio frequency front end (RFFE) module, including the power amplifier, connected to the first power path and the second power path. The first switching circuitry is controlled to connect the first power path and the third power path while the first supply voltage is not provided to the power amplifier through the first power path. The second switching circuitry is controlled to connect the second power path and the third power path while the second supply voltage is not provided to the power amplifier through the second power path.

## Description

### [Technical Field]

The following description relates to a power supply circuitry and an electronic device including the power supply circuitry.

### [Background Art]

An electronic device may include radio frequency front end (RFFE) modules for transmitting or receiving a signal. For example, an RFFE module may include a power amplifier (PA) for controlling a transmit power of a signal to be transmitted through an antenna connected to the RFFE module. The PA may obtain the transmit power based on a supply voltage from a power supply circuitry.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

One or more embodiments of the present disclosure are set out in the appended claims.

In embodiments, an electronic device is provided. The electronic device may comprise a processor comprising processing circuitry, a radio frequency (RF) transceiver, a first power supply circuitry for providing a power amplifier with a first supply voltage, a second power supply circuitry for providing the power amplifier or another power amplifier with a second supply voltage, a first power path connected to the first power supply circuitry, a second power path connected to the second power supply circuitry, wherein a third supply voltage is provided through the third power path, a first switching circuitry configured to connect or not connect the third power path to the first power path, a second switching circuitry configured to connect or not connect the third power path to the second power path, and a radio frequency front end (RFFE) module, including the power amplifier, connected to the first power path and the second power path. The first switching circuitry may be controlled to connect the first power path and the third power path while the first supply voltage is not provided to the power amplifier through the first power path. The second switching circuitry is controlled to connect the second power path and the third power path while the second supply voltage is not provided to the power amplifier through the second power path.

In embodiments, a power supply module is provided. A power supply module may comprise a first output port, a second output port; a third output port, a fourth output port, a first capacitor port, a second capacitor port, a first power supply circuitry for providing a first supply voltage, connected to the first output port, a second power supply circuitry for providing a second supply voltage, connected to the second output port, a first switching circuitry configured to connect or not connect the third output port to the first capacitor port, and a second switching circuitry configured to connect or not connect the fourth output port to the second capacitor port. The first switching circuitry may be controlled to connect the third output port to the first capacitor port while the first supply voltage is not provided through the first output port. The second switching circuitry may be controlled to connect the fourth output port to the second capacitor port while the second supply voltage is not provided through the second output port.

### [Description of the Drawings]

FIG. 1 is a block diagram of an electronic device in a network environment.
FIG. 2 indicates an example of an electronic device including a power supply circuitry and a radio frequency front end (RFFE) module.
FIG. 3 indicates an example of an electronic device including a power supply circuitry and RFFE modules.
FIGS. 4A and 4B indicate an example of an electronic device including a power supply circuitry and RFFE modules.
FIGS. 5A and 5B indicate an example of a change in a supply voltage for RFFE module.
FIGS. 6A, 6B, and 6C indicate an example of a change in a supply voltage for RFFE module.
FIGS. 7, 8, and 9 indicate an example of a change in a supply voltage for RFFE modules in dual connectivity (DC).
FIGS. 10, 11, and 12 indicate an example of a change in a supply voltage for RFFE modules in DC.
FIGS. 13A and 13B indicate examples of a third power source.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to a component (e.g., communication module, wireless communication module, substrate, printed circuit board (PCT), flexible PCB (FPCB), module, antenna, antenna element, circuitry, processor, chip, component, device) , terms referring to a RF-related component (front end module (FEM), power amplifier module (PAM), FEM including duplexer (FEMid), power amplifier module including duplexer (PAMid), low noise amplifier PAM including duplexer (LPAMid), radio frequency front end (RFFE), radio frequency integrated circuit (RFIC)), terms referring to a shape of a component (e.g., structure, structure member, support part, contact part, or protrusion), terms referring to a connection part between structures (e.g., connection part, contact part, support part, contact structure, conductive member, or assembly), and terms referring to circuitry (e.g., PCB, FPCB, signal line, feeding line, data line, RF signal line, antenna line, signal path, RF path, RF module, RF circuitry, splitter, divider, coupler, or combiner), and the like of an electronic device used in the following description are exemplified for convenience of explanation. Therefore, the present disclosure is not limited to terms described below, and another term having the same technical meaning may be used. Additionally, a term such as '...part', '...device', '...material', or '...assembly' and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' means at least one of elements from A (including A) to B (including B). Hereinafter, 'C' and/or 'D' means that at least one of 'C' or 'D', that is, {'C', 'D', 'C' and 'D'}.

The present disclosure describes various embodiments using terms used in a partial communication standard (e.g., 3rd Generation Partnership Project (3GPP), European Telecommunications Standards Institute (ETSI), extensible radio access network (xRAN), open-radio access network (O-RAN)), but this is only an example for explanation. Various embodiments of the present disclosure may be easily modified and applied in another communication system.

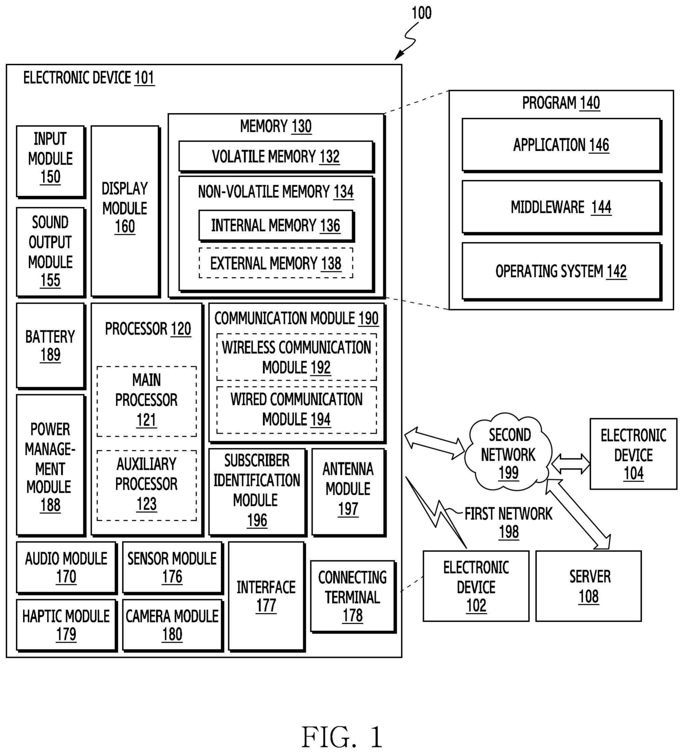

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

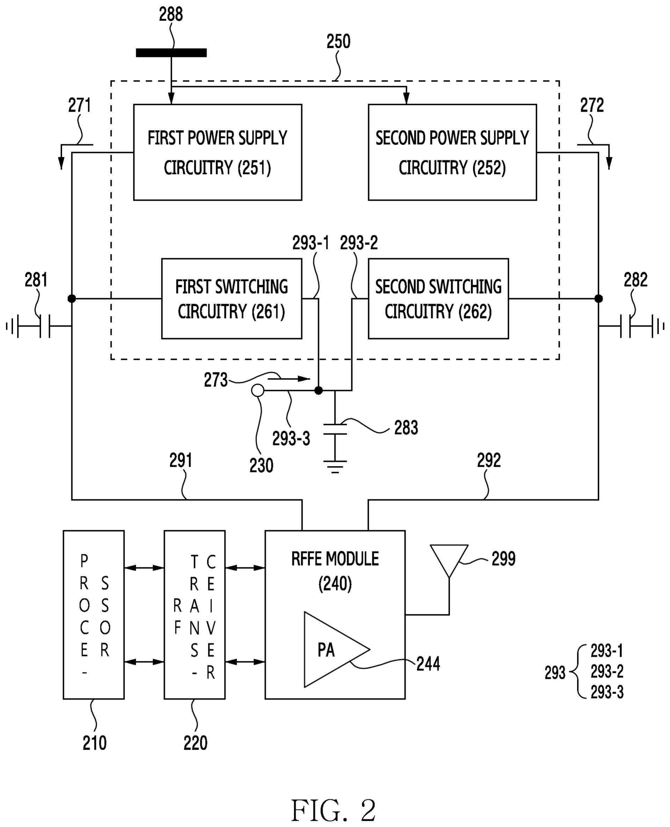

FIG. 2 indicates an example of an electronic device (e.g., an electronic device (101)) including a power supply circuitry and a radio frequency front end (RFFE) module.

Referring to FIG. 2, the electronic device 101 may include a processor 210, an RF transceiver 220, an RFFE module 240, a power supply circuitry 250, and an antenna 299. The electronic device 101 may include the processor 210. The processor 210 may, for example, include at least one of an application processor (AP) (e.g., the main processor 121 of FIG. 1) or a communication processor (CP) (e.g., the auxiliary processor 123 of FIG. 1). For example, the processor 210 may include an AP and a CP. For example, the processor may include the AP. For example, the processor 210 may include the CP. The processor 210 may control the RF transceiver 220 through a control interface. The processor 210 may control the RF transceiver 220 to transmit a signal through an antenna (e.g., the antenna 299). The processor 210 may control the RF transceiver 220 to receive a signal.

The electronic device 101 may include the RF transceiver 220. For example, the RF transceiver 220 may be implemented as a portion of a single chip (e.g., an RFIC chip) or a single package. The RF transceiver 220 may include a digital to analog converter (DAC) for converting a digital signal to an analog signal. The RF transceiver 220 may include a mixer and an oscillator (e.g., a local oscillator (LO)) or a voltage controlled oscillator (VCO) for up-conversion. The RF transceiver 220 may convert a baseband signal generated by the processor 210 into an RF signal. The RF transceiver 220 may provide the RF signal to at least one (e.g., the RFFE module 240) of RFFE modules. The RF transceiver 220 may include an analog to digital converter (ADC) for converting an analog signal to a digital signal. The RF transceiver 220 may include a mixer and an oscillator for down-conversion. The RF transceiver 220 may convert an RF signal received from an antenna (e.g., at least one of the antennas 299) into a baseband signal to enable processing by the processor 210. The RF transceiver 220 may include one or more transmit ports. The RF transceiver 220 may include one or more receiving ports. According to an embodiment, the RF transceiver 220 may control at least a portion of the RFFE module 240 through a mobile industry processor interface (MIPI) interface. According to an embodiment, the RF transceiver 220 may control at least a portion (e.g., a first power supply circuitry 251, a second power supply circuitry 252, a first switching circuitry 261, or a second switching circuitry 262) of the power supply circuitry 250 for providing a supply voltage through the MIPI interface.

The electronic device 101 may include one or more RFFE modules to support various frequency bands. For example, the electronic device 101 may include the RFFE module 240. The RFFE module 240 may include a power amplifier (PA) (e.g., a PA 244). The RFFE module 240 may be connected to the antenna 299 for transmitting a signal. The RFFE module including a power amplifier for a transmit path is illustrated in FIG. 2, but embodiments of the present disclosure are not limited thereto. For example, in addition to a PAMid including the transmit path, an LPAMid further including a component (e.g., a low noise amplifier (LNA)) for a receive path may also be used as an example of the RFFE module. The module including the power amplifier receiving the supply voltage from the power supply circuitry 250 (e.g., the first power supply circuitry 251, the second power supply circuitry 252, or a third power source 230) may be understood as the RFFE module of the electronic device 101 according to an embodiment of the present disclosure. In addition, for example, the RFFE module may be understood to include not only one module, but also the power amplifier and an FEMid, according to an implementation example.

The electronic device 101 may include the power supply circuitry 250. The power supply circuitry 250 may be controlled through the processor 210 and/or the RF transceiver 220. The power supply circuitry 250 may be configured to provide a supply voltage to the RFFE module (e.g., the RFFE module 240). The power supply circuitry 250 may provide a plurality of supply voltages for a plurality of RFFE modules. The power supply circuitry 250 may supply a supply voltage to each RFFE module of the plurality of RFFE modules. For example, the power supply circuitry 250 may be a form in which a plurality of modulators are implemented as one module (or IC). The power supply circuitry 250 may be a power supply module including a plurality of cores. As an example, the power supply module may include the first power supply circuitry 251 and the second power supply circuitry 252. For another example, the power supply circuitry 250 may include the first power supply circuitry 251 and the second power supply circuitry 252 implemented as separate modules. Power being supplied to the RFFE module may indicate that a supply voltage is applied for the PA of the RFFE module. The power supply circuitry 250 may output a plurality of supply voltages for the plurality of RFFE modules. For example, the power supply circuitry 250 may output a first supply voltage 271 (V_{CC1}) from the first power supply circuitry 251 through a first power path 291, and a second supply voltage 272 (V_{cc2}) from the second power supply circuitry 252 through a second power path 292. For example, the first supply voltage 271 may be provided to at least one of the plurality of RFFE modules of the electronic device 101. For example, the second supply voltage 272 may be provided to at least one of the plurality of RFFE modules of the electronic device 101. As a non-limiting example, in case that the power supply circuitry 250 is implemented as a module, the first power path 291 may be formed across a first output port of the module. The second power path 292 may be formed across a second output port of the module.

A current consumed by the power amplifier in the electronic device 101 may greatly influence a power consumption of the device and thus battery usage and usage time of the device available to a user. According to development of communication technology, average power tracking (APT) technology may be used to provide a supply voltage of appropriate magnitude. APT is technology for providing a DC voltage of magnitude according to a state of a communication channel to a power amplifier. For the supply voltage according to the APT, the power supply circuitry 250 may be configured to provide a power source to the power amplifier at a specified magnitude through a DC-DC converter. In addition to the APT, terms such as an APT mode, an APT state, an APT operation, an APT method, a variable DC voltage mode, a variable DC power mode, and/or a term having the same technical/functional meaning may be used. The power supply circuitry 250 may be configured to provide the supply voltage based on the APT. For example, the first power supply circuitry 251 may be configured to provide the first supply voltage 271 based on the APT. The first power supply circuitry 251 may generate the first supply voltage 271 according to the APT from a voltage from the battery 288. For example, the second power supply circuitry 252 may be configured to provide the second supply voltage 272 based on the APT. The second power supply circuitry 252 may generate the second supply voltage 272 according to the APT from the voltage from the battery 288. In order to generate the supply voltage according to the APT, each power supply circuitry may include an APT switch (not shown) and a buck converter circuitry (not shown). The APT switch may be configured to electrically connect a capacitor to the buck converter circuitry. The supply voltage according to the APT may be affected by the capacitor. A DC voltage is generated through the buck converter circuitry, and the capacitor may be used to maintain a constant voltage. For example, the first power supply circuitry 251 may be electrically connected to a first capacitor 281 to maintain constantly the first supply voltage 271 according to APT. For example, the second power supply circuitry 252 may be electrically connected to a second capacitor 282 to maintain constantly the second supply voltage 272 according to APT.

The buck converter circuitry used to generate the supply voltage according to the APT may be configured to charge and discharge the capacitor using a electromotive force of an inductor through a switching element. Noise according to this switching operation may be detected as an unnecessary component through the PA (e.g., the PA 244). In addition, in case that current consumption at the PA 244 exceeds an allowable value in the power supply circuitry 250 (e.g., a current exceeding an allowable value is supplied to a regulator of the power supply circuitry 250, and exceeding a current limit capacity of the inductor), it may be difficult to supply a stable voltage to the PA 244 and/or damage may occur to the power supply circuitry 250. In addition, a multilayer ceramic capacitor (MLCC) may be considered to support a large capacity within a limited mounting area. However, if the buck converter circuitry of the power supply circuitry is switched to provide the supply voltage according to the APT, physical deformation of the capacitor may be caused, and the PCB in which the MLCC capacitor is disposed may vibrate as the voltage applied across both ends of the MLCC capacitor changes. These physical deformation and vibration may generate audible noise.

To alleviate one or more of the above-described problems, a circuitry structure for providing a third supply voltage from the third power source 230, separately from the first power supply circuitry 251 and the second power supply circuitry 252 is described in the present disclosure. The power supply circuitry 250 may include the first switching circuitry 261 and the second switching circuitry 262. The first switching circuitry 261 may be configured to connect or to not connect the first power path 291 and the third power path 293, selectively. The second switching circuitry 262 may be configured to connect or to not connect the second power path 292 and the third power path 293. In case that it is difficult (or not desirable for any of the above reasons) to provide the first supply voltage 271 through the first power supply circuitry 251, the first switching circuitry 261 may electrically connect the first power path 291 and the third power path 293. The third supply voltage 273, instead of the first supply voltage 271, may be provided to the RFFE module 240 through the first power path 291. As an example, the third supply voltage 273 may be provided to the PA 244 of the RFFE module 240. In case that it is difficult to provide the second supply voltage 272 through the second power supply circuitry 252, the second switching circuitry 262 may electrically connect the second power path 292 and the third power path 293. The third supply voltage 273, instead of the second supply voltage 272, may be provided to the RFFE module 240 through the second power path 292. As an example, the third supply voltage 273 may be provided to the PA 244 of the RFFE module 240. The PA 244 of the RFFE module 240 may obtain a supply voltage through one of the first power path 291 and the second power path 292 according to a control of the processor 210 or the RF transceiver 220. In case that the first power path 291 is connected to the PA 244, the first supply voltage 271 or the third supply voltage 273 may be provided to the PA 244. In case that the second power path 292 is connected to the PA 244, the second supply voltage 272 or the third supply voltage 273 may be provided to the PA 244. The electronic device 101 according to embodiments of the present disclosure may cause the electronic device 101 to operate normally by supplying a separate supply voltage (e.g., the third supply voltage 273) to the PA 244 of the RFFE module 240 through another path, even if a problem occurs in the power supply circuitry providing the supply voltage to the PA 244 of the RFFE module 240. In other words, the normal operation of the electronic device 101 may be maintained under any circumstance by using an alternative power source.

The control of the first and second switching circuitries (and also switching circuitries of the RFFE modules described later in this disclosure) may be performed by a controller or processor of the electronic device. For example, if a power required by a RFFE module is detected as exceeding a threshold, the first/second switching circuitries may be controlled to provide the third supply voltage to the RFFE module. Alternatively or additionally, if the characteristic of the required power that leads to undesirable vibration of one of the capacitors 281 or 282 is detected, the first/second switching circuitries may be controlled to provide the third supply voltage to the RFFE module.

Expressed in an alternative manner, when the first switching circuitry (261) is in a first state (i.e. first switching state) it is configured to disconnect the third supply voltage 273 from the RFFE module (240)/PA (244) (e.g. disconnect it from the first power path 291), and when the first switching circuitry (261) is in a second state (i.e. second switching state) it is configured to connect the third supply voltage 273 to the RFFE module (240)/PA(244) (e.g. via the first power path 291). When the second switching circuitry (262) is in a first state (i.e. first switching state) it is configured to disconnect the third supply voltage 273 from the RFFE module (240)/PA (244) (e.g. disconnect it from the second power path 292), and when the second switching circuitry (262) is in a second state (i.e. second switching state) it is configured to connect the third supply voltage 273 to the RFFE module (240)/PA(244) (e.g. via the first power path 292). It is envisaged, although not exclusively, that the first and second power supply circuitries will not be outputting their respective supply voltages when the first and second switching circuitries are in their respective second states. For example, the first and/or second switching circuitries will be in, or switch to, their second state (i.e. connect the third supply voltage to the first/second power paths/RFFE module) when the first/second supply voltages are not provided to the RFFE during operation of the power amplifier. Each of the switching circuitries considered in this disclosure may be described as having a plurality of different states, where the connections (i.e. electrical path) provided by each state differ.

Throughout this disclosure, specific switching circuitries and power paths are considered in the supply of the first, second, and third supply voltages to one or more RFFE modules. However, any suitable arrangement may be used to provide the functionality of providing the third supply voltage to a RFFE module as an alternative to the first supply voltage or the second supply voltage to address or alleviate one or more of the problems discussed above, where the third supply voltage is provided by a power supply/module separate or different to the power supply/modules that provides the first and second supply voltages.

The third supply voltage 273 from the third power source 230 may be provided to the power supply circuitry 250 through the third power path 293. For example, the third power path 293 may include a first portion 293-1 connected to the first switching circuitry 261, a second portion 293-2 connected to the second switching circuitry 262, and a third portion 293-3 connected to the third power source 230. For example, the third supply voltage 273 may be transferred to the first portion 293-1 and/or the second portion 293-2 through the third portion 293-3. According to an embodiment, in case that the power supply circuitry 250 is implemented as one module, the first portion 293-1 may be connected to the first switching circuitry 261 through a first capacitor port of the module, and the second portion 293-2 may be connected to the second switching circuitry 262 through a second capacitor port of the module. A third APT capacitor 283 may be electrically connected to the third power path 293. The third APT capacitor 283 may be used to stably provide the third supply voltage 273. For example, in case that the first power path 291 and the third power path 293 are connected by the first switching circuitry 261, the third supply voltage 273 of the third power source 230 may be provided to the RFFE module 240 through the third power path 293 and the first power path 291. The third supply voltage 273 may be affected by capacitors (e.g., the third APT capacitor 283) connected on an electrical path to the third power path 293 and the first power path 291. As an example, a higher capacitance (e.g., the third APT capacitor 283 has a capacitance of about 4.7 uF) may be required to stably maintain the voltage for higher output signals. For example, when the second power path 292 and the third power path 293 are connected by the second switching circuitry 262, the third supply voltage 273 of the third power source 230 may be provided to the RFFE module 240 through the third power path 293 and the second power path 292. The third supply voltage 273 may be affected by capacitors (e.g., the third APT capacitor 283) connected on the electrical path to the third power path 293 and the second power path 292. As an example, a high capacity capacitance (e.g., the third APT capacitor 283 has a capacitance of about 4.7 uF) may be required to stably maintain a voltage for a high power signal.

The provision of the third supply voltage may not involve an inductor (e.g. it may be provided directly from a battery or an envelope tracking power supply) and/or have capacitors of different values. Furthermore, the third supply voltage may be able to be provided with a higher current than the first and/or second supply voltages. Consequently, by virtue of using the third supply voltage, one or more of the above-mentioned problems may be addressed.

Although the above implementation includes a single RFFE module, as is explained in more detail below, the electronic device may include any number of RFFE modules and various arrangements of switching circuits in the power supply circuitry 250 and/or one or more of the RFFE modules may be used to allow one or more of the first, second, or third supply voltages to be provided to the RFFE modules.

In case that the first power supply circuitry 251 or the second power supply circuitry 252 is damaged and difficult to use, or a current tolerance is exceeded, the third power source 230 may be used. For example, the third power source 230 may correspond to the battery 288. The third supply voltage 273 may be a voltage (V_{bat}) provided from the battery 288. For example, the third power source 230 may correspond to a third power supply circuitry (not shown) distinguished from the first power supply circuitry 251 and the second power supply circuitry 252. The third supply voltage 273 may be a voltage provided from the third power supply circuitry. The third power supply circuity may take any suitable form such as an APT supply, a supply direct from a battery, an envelope tracking supply, or a predetermined power supply (e.g. constant voltage or one of a number of constant voltages).

The third supply voltage 273 may replace the first supply voltage 271 or replace the second supply voltage 272 or replace both the first supply voltage 271 and the second supply voltage 272. For example, in case that it is difficult to use the first power supply circuitry 251 (e.g., damage of the first power supply circuitry 251, excess of an allowable current (i.e. first power supply circuitry cannot supply sufficient current), or generation of audible noise), the first switching circuitry 261 may operate in a closed state, and the second switching circuitry 262 may be in a open state. In the closed state, the first switching circuitry 261 may be controlled to electrically connect the first power path 291 and the third power path 293. The third supply voltage 273, instead of the first supply voltage 271, may be provided to the RFFE module 240 through the first power path 291. While the third supply voltage 273 is provided, the second supply voltage 272 may be provided to the RFFE module 240 or another RFFE module (not shown) through the second power path 292. For example, in case that it is difficult to use the second power supply circuitry 252 (e.g., damage of the second power supply circuitry 252, excess of an allowable current (i.e. second power supply circuit cannot supply sufficient current), or generation of audible noise), the first switching circuitry 261 may be in the open state, and the second switching circuitry 262 may operate in the closed state. In the closed state, the second switching circuitry 262 may be controlled to electrically connect the second power path 292 and the third power path 293. The third supply voltage, instead of the second supply voltage 273, may be provided to the RFFE module 240 through the second power path 292. While the third supply voltage 273 is provided, the first supply voltage 271 may be provided to the RFFE module 240 or another RFFE module (not shown) through the first power supply path 291. For example, in case that it is difficult to use both the first power supply circuitry 251 and the second power supply circuitry 252, both the first switching circuitry 261 and the second switching circuitry 262 may operate in the closed state. The third supply voltage 273, instead of the first supply voltage 271, may be provided to the RFFE module 240 or another RFFE module (not shown) through the first power path 291. Likewise, the third supply voltage 273, instead of the second supply voltage 272, may be provided to the RFFE module 240 or another RFFE module (not shown) through the second power path 292.

Hereinafter, in the present disclosure, an example in which the supply voltage (e.g., the first supply voltage 271 or the second supply voltage 272) according to the APT is provided in the first power supply circuitry 251 and/or the second power supply circuitry 252 is described, but embodiments of the present disclosure are not limited thereto. It can also be understood as an embodiment of the present disclosure that the third power source 230 is connected to the switching circuitry (e.g., the first switching circuitry 261 or the second switching circuitry 262) of the power supply circuitry to which the supply voltage according to a method other than the APT (e.g., envelope tracking (ET)) is provided.

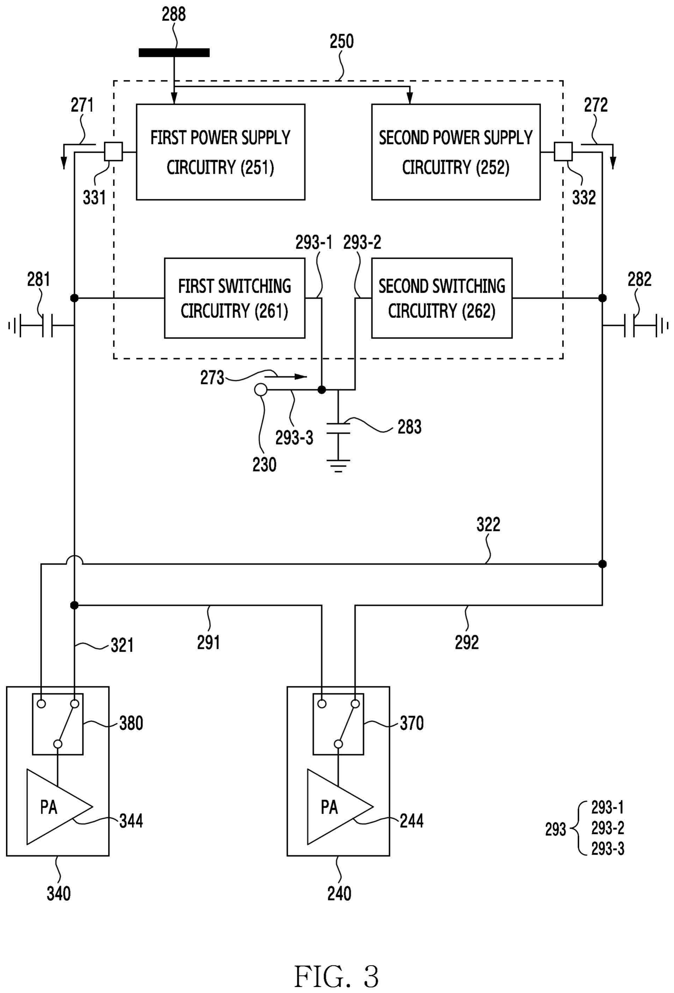

FIG. 3 indicates an example of an electronic device (e.g., an electronic device 101) including a power supply circuitry (e.g., a power supply circuitry 250) and RFFE modules. In FIG. 3, an example for providing a supply voltage (e.g., a third supply voltage 273) of a separate power source (e.g., a third power supply voltage 273) to the RFFE module through switching circuitries (e.g., a first switching circuitry 261 or a second switching circuitry 262) of the power supply circuitry 250 is described. The same reference number may be used for the same description.

Referring to FIG. 3, the electronic device 101 may include a processor 210, an RF transceiver 220, a first RFFE module 240, a second RFFE module 340, a power supply circuitry 250, and an antenna (not shown) (e.g., an antenna 299 of FIG. 2). The second RFFE module 340 may include a power amplifier (PA) (e.g., a PA 344). For each component, the descriptions of FIG. 2 may be referred to.

The electronic device 101 may include various RFFE modules. In order to effectively provide a supply voltage to a power amplifier of each RFFE module, at least a portion of the RFFE modules may include a switching circuitry. The supply voltage provided to the power amplifier of the RFFE module may vary through the switching circuitry. For example, the first RFFE module 240 may include a third switching circuitry 370. The third switching circuitry 370 may be configured to electrically connect a first power path 291 or a second power path 292 to a PA 244, selectively. For example, the second RFFE module 340 may include a fourth switching circuitry 380. The fourth switching circuitry 380 may be configured to electrically connect a fourth power path 321 or a fifth power path 322 to the PA 344, selectively. The fourth power path 321 may be connected to a first power supply circuitry 251 and the first switching circuitry 261. For example, the fourth power path 321 may indicate a path in which a first supply voltage 271 from the first power supply circuitry 251 is transferred to the second RFFE module 340. For example, the fourth power path 321 may be branched from a node of the first power path 291. For example, the fourth power path 321 may be electrically connected to a first output port 331 of the power supply circuitry 250. The first output port 331 may be connected to the first power supply circuitry 251 and the first switching circuitry 261. The fifth power path 322 may be connected to a second power supply circuitry 252 and the second switching circuitry 262. For example, the fifth power path 322 may indicate a path in which a second supply voltage 272 from the second power supply circuitry 252 is transferred to the second RFFE module 340. For example, the fifth power path 322 may be branched from a node of the second power path 292. For example, the fifth power path 322 may be electrically connected to a second output port 332 of the power supply circuitry 250. The second output port 332 may be connected to the second power supply circuitry 252 and the second switching circuitry 262.

In case that the electronic device 101 performs communication according to dual connectivity (DC) or performs a UL MIMO operation, two or more RFFE modules may be activated. Supply voltages may be provided to power amplifiers of two or more RFFE modules. For example, a first PA 244 of the first RFFE module 240 and a second PA 344 of the second RFFE module 340 may be activated. A supply voltage may be provided to the first PA 244 and the second PA 344, respectively. The third switching circuitry 370 and the fourth switching circuitry 380 may operate according to a control of the processor 210 or the RF transceiver 220. For example, as illustrated in FIG. 3, the second power path 292 may be electrically connected to the first PA 244 through the third switching circuitry 370. The second supply voltage 272 of the second power supply circuitry 252 may be provided to the first PA 244 through the second power path 292, or the third supply voltage 273 of the third power source 230 may be provided through the third power path 293 and the second power path 292. The fourth power path 321 may be electrically connected to the second PA 344 through the fourth switching circuitry 380. The first supply voltage 271 of the first power supply circuitry 251 may be provided to the second PA 344 through the fourth power path 321 or the third supply voltage 273 of the third power source 230 may be provided through the third power path 293 and the fourth power path 321.

For another example, a path disposition different from that illustrated in FIG. 3 may be configured. The first power path 291 may be electrically connected to the first PA 244 through the third switching circuitry 370. The first supply voltage 271 of the first power supply circuitry 251 may be provided to the first PA 244 through the first power path 291 or the third supply voltage 273 of the third power source 230 may be provided through the third power path 293 and the first power path 291. The fifth power path 322 may be electrically connected to the second PA 344 through the fourth switching circuitry 380. The second supply voltage 272 of the second power supply circuitry 252 may be provided to the second PA 344 through the fifth power path 322, or the third supply voltage 273 of the third power source 230 may be provided through the third power path 293 and the fifth power path 322 to the second PA 344.

According to an embodiment, the third supply voltage 273 may replace the first supply voltage 271, replace the second supply voltage 272, or replace both the first supply voltage 271 and the second supply voltage 272. For example, in case that it is difficult to use the first power supply circuitry 251 (e.g., damage of the first power supply circuitry 251, excess of an allowable current, or generation of audible noise), the first switching circuitry 261 may operate in the closed state, and the second switching circuitry 262 may be in the open state. The first switching circuitry 261 may be controlled to electrically connect the fourth power path 321 and the third power path 293. The third supply voltage 273, instead of the first supply voltage 271, may be provided to the second PA 344 of the second RFFE module 340 through the fourth power path 321. While the third supply voltage 273 is provided to the second PA 344 of the second RFFE module 340, the second supply voltage 272 may be provided to the first PA 244 of the first RFFE module 240 through the second power path 292. For example, in case that it is difficult to use the second power supply circuitry 252 (e.g., damage of the second power supply circuitry 252, excess of an allowable current, or generation of audible noise), the first switching circuitry 261 may be in the open state, and the second switching circuitry 262 may operate in the closed state. The second switching circuitry 262 may be controlled to electrically connect the second power path 292 and the third power path 293. The third supply voltage 273, instead of the second supply voltage 272, may be provided to the first PA 244 of the first RFFE module 240 through the second power path 292. While the third supply voltage 273 is provided to the first RFFE module 240, the first supply voltage 271 may be provided to the second PA 344 of the second RFFE module 340 through the fourth power path 321. For example, in case that it is difficult to use both the first power supply circuitry 251 and the second power supply circuitry 252, both the first switching circuitry 261 and the second switching circuitry 262 may operate in the closed state. The third supply voltage 273, instead of the first supply voltage 271, may be provided to the second PA 344 of the second RFFE module 340 through the fourth power path 321. Likewise, the third supply voltage 273, instead of the second supply voltage 272, may be provided to the first PA 244 of the first RFFE module 240 through the second power path 292. As explained above and as illustrated in FIG. 3, by virtue of the first switching circuitry 261 and the second switching circuitry 262, any of the first, second, and third supply voltages can be provided to each of the first RFFE 240 and the second RFFE 340, and additionally by virtue of the third switching circuitry 270 and the fourth switching circuitry 380, any of the first, second, and third supply voltages can be provided to each of the first PA 244 and the second PA 344.

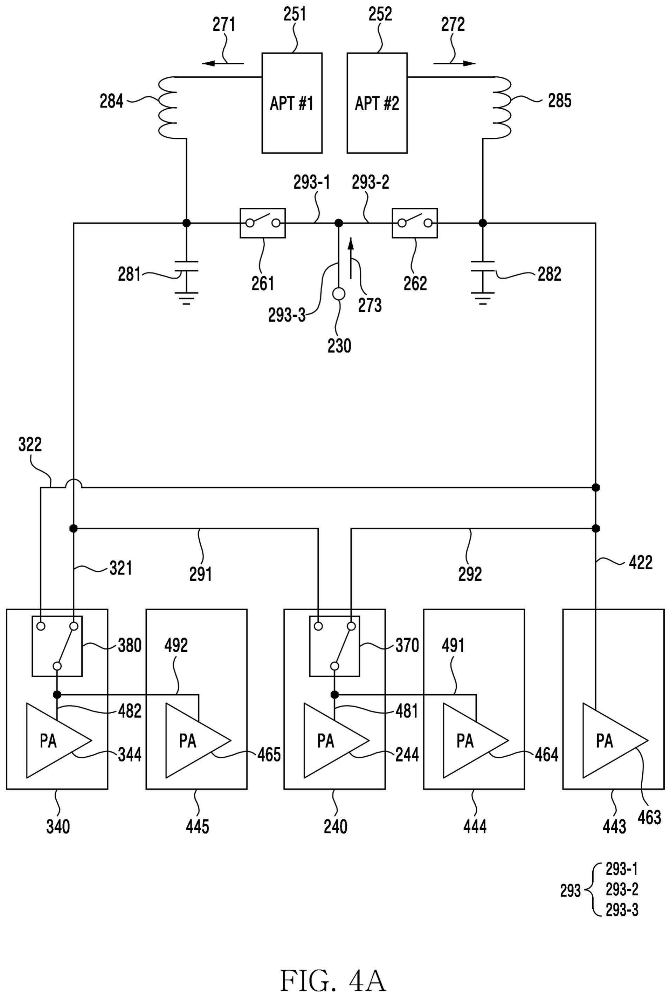

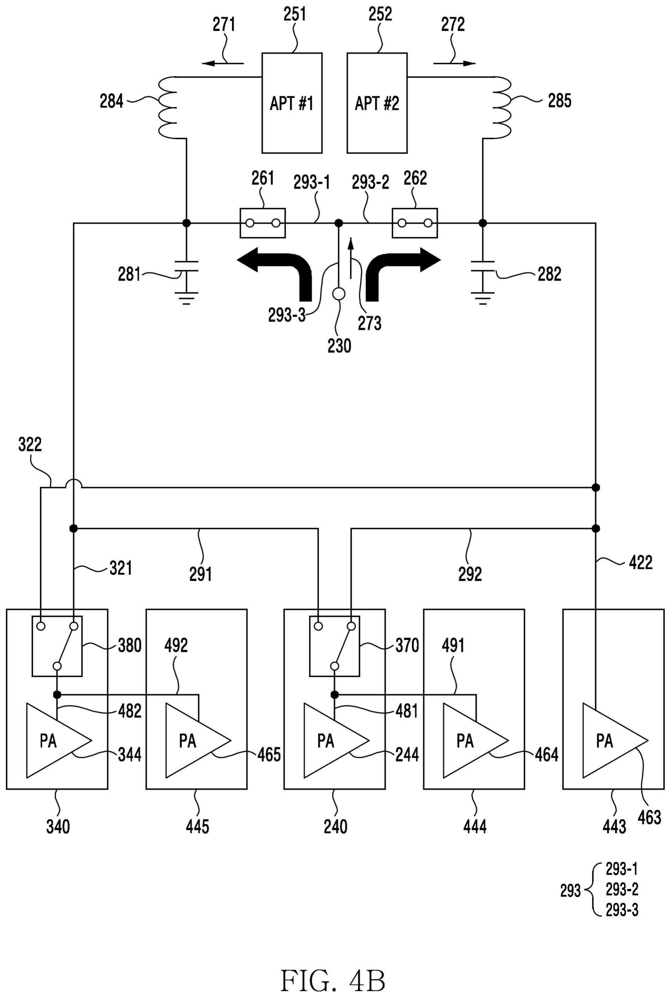

FIGS. 4A and 4B indicates examples of an electronic device (e.g., an electronic device 101), including a power supply circuitry (e.g., a power supply circuitry 250) and RFFE modules.

Referring to FIGS. 4A and 4B, the electronic device 101 may include a processor 210, an RF transceiver 220, RFFE modules, a power supply circuitry 250, and an antenna (e.g., an antenna 299 of FIG. 2). For each component, the descriptions of FIGS. 2 and 3 may be referred to.

The electronic device 101 may include RFFE modules to support various frequency bands. For example, the electronic device 101 may include a first RFFE module 240, a second RFFE module 340, a third RFFE module 443, a fourth RFFE module 444, and a fifth RFFE module 445. The first RFFE module 240 may include a first PA 244. The second RFFE module 340 may include a second PA 344. The third RFFE module 443 may include a third PA 463. The fourth RFFE module 444 may include a fourth PA 464. The fifth RFFE module 445 may include a fifth PA 465. For each RFFE module, a description of the RFFE module 240 of FIG. 2 may be referred to. For each PA, a description of the PA 244 of FIG. 2 may be referred to.

The electronic device 101 may include the power supply circuitry 250. The power supply circuitry 250 may be controlled by the processor 120 and/or the RF transceiver 220. The electronic device 101 may include a first APT capacitor 281 and a first inductor 284. The buck converter circuitry of a first power supply circuitry 251 may be configured to output a first supply voltage 271 through the first inductor 284. The first power supply circuitry 251 may be electrically connected to the first capacitor 281 to maintain constantly the first supply voltage 271 according to APT. The electronic device 101 may include a second APT capacitor 282 and a second inductor 285. The buck converter circuitry of the second power supply circuitry 252 may be configured to output a second supply voltage 272 through the second inductor 285. The second power supply circuitry 252 may be electrically connected to the second capacitor 282 to maintain constantly the second supply voltage 272 according to the APT.

The power supply circuitry 250 may be configured to supply power to a plurality of RFFE modules (e.g., the first RFFE module 240, the second RFFE module 340, the third RFFE module 443, the fourth RFFE module 444, and the fifth RFFE module 445). The power supply circuitry 250 may provide a plurality of supply voltages for the plurality of RFFE modules. The power supply circuitry 250 may provide a supply voltage to each RFFE module of the plurality of RFFE modules. According to an embodiment, the power supply circuitry 250 may output the first supply voltage 271 (V_{CC1}) from the first power supply circuitry 251 through a first power path 291 and the second supply voltage 272 (V_{cc2}) from the second power supply circuitry 252 through the second power path 292. According to an embodiment, the power supply circuitry 250 may output the first supply voltage 271 (V_{CC1}) from the first power supply circuitry 251 through the first power path 291 and the third supply voltage 273 (V_{cc3}) from a third power source 230 through the second power path 292. According to an embodiment, the power supply circuitry 250 may output the third supply voltage 273 (V_{cc3}) from the third power source 230 through the first power path 291 and the second supply voltage 272 (V_{cc2}) from the second power supply circuitry 252 through the second power path 292. According to an embodiment, the power supply circuitry 250 may output the third supply voltage 273 (V_{cc3}) from the third power source 230 through the first power source path 291 and the third supply voltage 273 (V_{cc3}) from the third power source 230 through the second power source path 292.

Various supply voltages may be provided to each RFFE module (or the PA of the corresponding RFFE module) in various methods. The first supply voltage 271 may be provided to the first RFFE module 240, the second RFFE module 340, the fourth RFFE module 444, and/or the fifth RFFE module 445. The second supply voltage 272 may be provided to the first RFFE module 240, the second RFFE module 340, the third RFFE module 443, the fourth RFFE module 444, and/or the fifth RFFE module 445. The third supply voltage 273 may be provided to the first RFFE module 240, the second RFFE module 340, the third RFFE module 443, the fourth RFFE module 444, and/or the fifth RFFE module 445. To drive the first PA 244, the electronic device 101 may supply one of the first supply voltage 271, the second supply voltage 272, or the third supply voltage 273 to the first PA 244 of the first RFFE module 240. As a non-limiting example, the first RFFE module 240 may be configured to perform processing signals in a frequency band of a first frequency range. As an example, the first frequency range may include a frequency band of a high frequency band (e.g., an ultra-high band (UHB) of about 3.4 GHz or more). To drive the second PA 344, the electronic device 101 may supply one of the first supply voltage 271, the second supply voltage 272, or the third supply voltage 273 to the second PA 344 of the second RFFE module 340. As a non-limiting example, the second RFFE module 340 may be configured to perform processing the signals in the frequency band of the first frequency range. As an example, the first frequency range may include a high band (e.g., the UHB of about 3.4 GHz or more). To drive the third PA 463, the electronic device 101 may supply one of the second supply voltage 272 or the third supply voltage 273 to the third PA 463 through a sixth power path 422. Herein, the sixth power path 422 may be branched from a node of the second power path 292. As a non-limiting example, the third RFFE module 443 may be configured to perform processing signals in a frequency band of a second frequency range. As an example, the second frequency range may include a low band (e.g., a low-band (LB) of about 1 GHz or less, or a GSM frequency band). To drive the fourth PA 464, the electronic device 101 may supply one of the first supply voltage 271, the second supply voltage 272, or the third supply voltage 273 to the fourth PA 464 of the fourth RFFE module 444. As a non-limiting example, the fourth RFFE module 444 may be configured to perform processing signals in a frequency band for EUTRA-NR (EN)- dual connectivity (DC). As an example, the frequency band may include a frequency band of a mid-band (e.g., a frequency band greater than or equal to about 1 GHz and less than about 2.3 GHz) and a high band (e.g., a frequency band greater than or equal to about 2.3 GHz). To drive the fifth PA 465, the electronic device 101 may supply one of the first supply voltage 271, the second supply voltage 272, or the third supply voltage 273 to the fifth PA 465 of the fifth RFFE module 445. As a non-limiting example, the fifth RFFE module 445 may be configured to perform processing signals in a frequency band between the first frequency range and the second frequency range. As an example, the frequency band may include the mid-band (e.g., the frequency band greater than or equal to about 1 GHz and less than about 2.3 GHz) and the high band (e.g., the frequency band greater than or equal to about 2.3 GHz).

According to an embodiment, the third switching circuitry 370 may be used to provide a supply voltage to each of the first PA 244 and the fourth PA 464. The third switching circuitry 370 may connect the first power path 291 or the second power path 292 to a first PA path 481, selectively. The first PA 244 may obtain the supply voltage through the first PA path 481. For example, in case that the third switching circuitry 370 electrically connects the second power path 292 to the first PA path 481, the first PA 244 may obtain the second supply voltage (V_{cc2}) through the second power path 292 and the first PA path 481. The third switching circuitry 370 may be connected to a first subsequent power path 491. A subsequent power path may be referred to as a continuous power path, a sub-power path, an additional power path, an auxiliary power path, a supplemental power path, an extended power path, and/or an equivalent technical term in addition to the subsequent power path in terms of supplying power by being connected from a RFFE module to another RFFE module. The third switching circuitry 370 may connect the first power path 291 or the second power path 292 to the first subsequent power path 491, selectively. The fourth PA 264 may obtain the supply voltage through the first subsequent power path 491. For example, in case that the third switching circuitry 370 electrically connects the second power path 292 to the first subsequent power path 491, the fourth PA 464 may obtain the second supply voltage (V_{cc2}) through the second power path 292 and the first subsequent power path 491. For example, the first subsequent power path 491 may be connected to the first PA path 481.

According to an embodiment, a fourth switching circuitry 380 may be used to provide a supply voltage to each of the second PA 344 and the fifth PA 465. The fourth switching circuitry 380 may connect a fourth power path 321 or a fifth power path 322 to a second PA path 482, selectively. The second PA 344 may obtain the supply voltage through the second PA path 482. For example, in case that the fourth switching circuitry 380 electrically connects the fourth power path 321 and the second PA path 482, the second PA 344 may obtain the first supply voltage (V_{cc1}) through the fourth power path 321 and the second PA path 482. The fourth switching circuitry 380 may be connected to a second subsequent power path 492. The fourth switching circuitry 380 may connect the fourth power path 321 or the fifth power path 322 to the second subsequent power path 492, selectively. The fifth PA 465 may obtain the supply voltage through the second subsequent power path 492. For example, in case that the fourth switching circuitry 380 electrically connects the fifth power path 322 and the second subsequent power path 492, the fifth PA 465 may obtain the second supply voltage (V_{cc2}) through the fifth power path 322 and the second subsequent power path 492.

In FIG. 4A, a circuitry is illustrated in which each of the first switching circuitry 261 and the second switching circuitry 262 is open. In the circuitry structure, a first supply voltage 271 or a second supply voltage 272 may be provided to the first PA 244. In the circuitry structure, the first supply voltage 271 or the second supply voltage 272 may be provided to the second PA 344. In the circuitry structure, the second supply voltage 272 may be provided to the third PA 463. In the circuitry structure, the first supply voltage 271 or the second supply voltage 272 may be provided to the fourth PA 464. In the circuitry structure, the first supply voltage 271 or the second supply voltage 272 may be provided to the fifth PA 465.

Meanwhile, in FIG. 4B a circuitry is illustrated in which each of the first switching circuitry 261 and the second switching circuitry 262 is closed. In the circuitry structure, the third supply voltage 273 may be provided to the first PA 244. The third supply voltage 273 may be provided to the second PA 344. The third supply voltage 273 may be provided to the third PA 463. The third supply voltage 273 may be provided to the fourth PA 464. The third supply voltage 273 may be provided to the fifth PA 465.

Only a state in which both the first switching circuitry 261 and the second switching circuitry 262 are closed or a state in which both the first switching circuitry 261 and the second switching circuitry 262 are open is illustrated in FIGS. 4A and 4B, but embodiments of the present disclosure are not limited thereto. Various supply voltages may be provided to each PA through a state in which the first switching circuitry 261 is closed and the second switching circuitry 262 is open or a state in which the second switching circuitry 262 is closed and the first switching circuitry 261 is open.

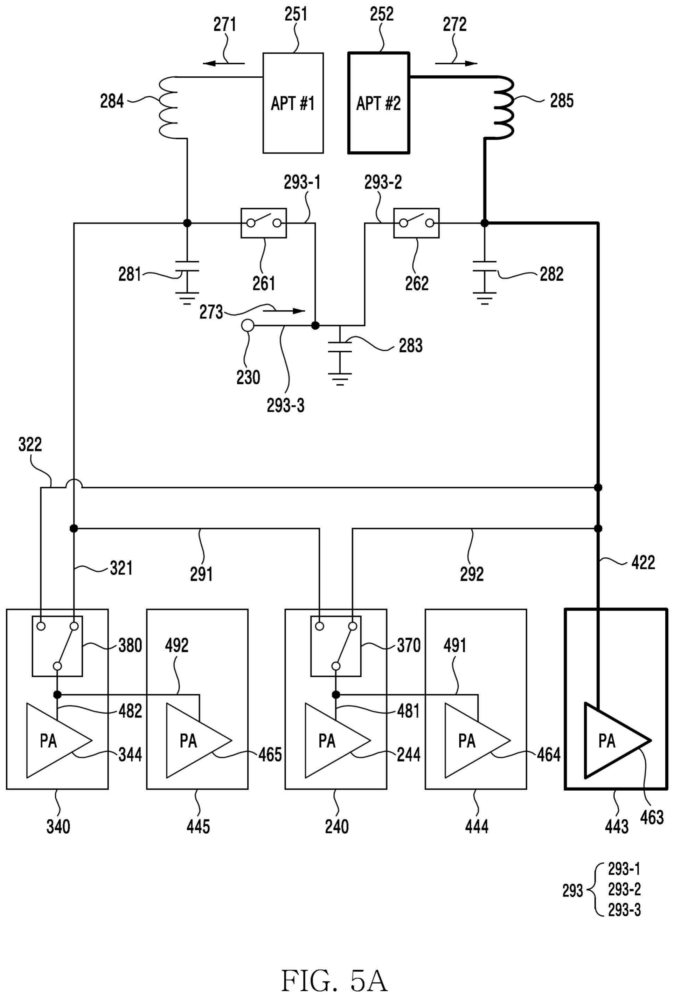

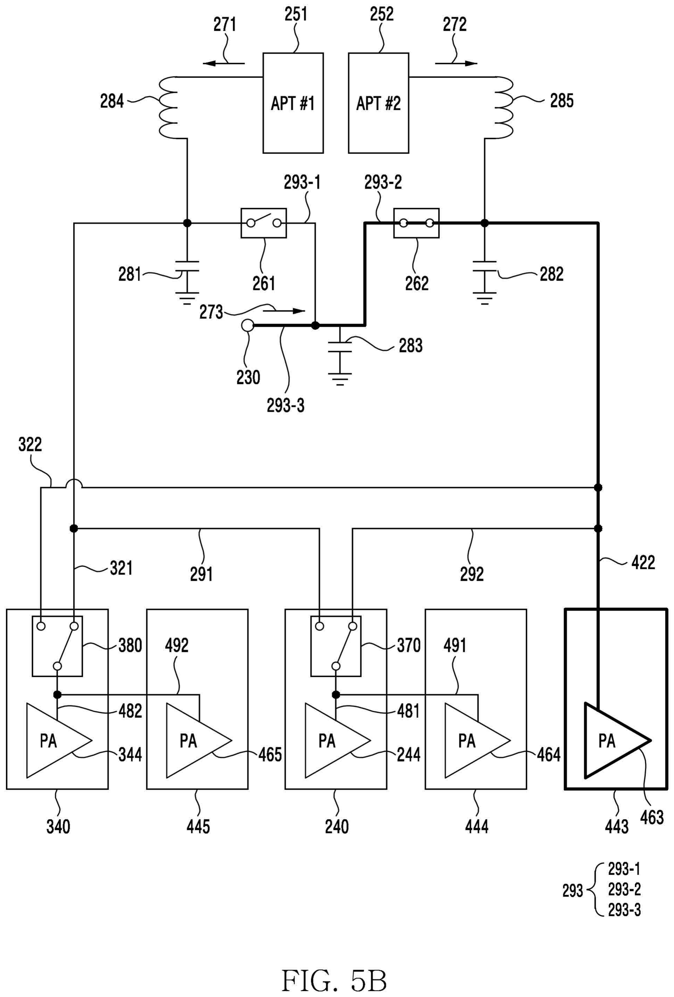

FIGS. 5A and 5B indicates examples of a change in a supply voltage for a RFFE module. An electronic device 101 may include a processor 210, an RF transceiver 220, RFFE modules (e.g., a first RFFE module 240, a second RFFE module 340, a third RFFE module 443, a fourth RFFE module 444, a fifth RFFE module 445), and a power supply circuitry 250. For each component, the descriptions of FIGS. 2, 3, 4A, and 4B may be referred to.

Referring to FIG. 5A, the electronic device 101 may transmit a signal through the third RFFE module 443. The electronic device 101 may transmit a signal through a third PA 463 in a frequency band (e.g., a low-band (LB) of less than about 1 GHz, or a GSM frequency band) supported in the third RFFE module 443. A second switching circuitry 262 may be in an open state. A second power supply circuitry 252 may generate a second supply voltage 272 based on APT. The second supply voltage 272 according to the APT may be provided to a third PA 463 of the third RFFE module 443 through a sixth power path 422. In providing the second supply voltage 272, a change of a power source may be required as the second power supply circuitry 252 is damaged and difficult to use, a current tolerance is exceeded, a problem by audible noise, and/or noise in a specific frequency band occur.

Referring to FIG. 5B, the second switching circuitry 262 may operate according to a control of the processor 210 and/or the RF transceiver 220 of the electronic device 101. A state of the second switching circuitry 262 may change from an open state to a closed state. The second switching circuitry 262 may electrically connect the sixth power path 422 (e.g., including at least a portion of the second power path 292) and a third power path 293. Since the sixth power path 422 is connected to the third power path 293, a third supply voltage 273 of a third power source 230 may be provided to the third PA 463 of the third RFFE module 443.

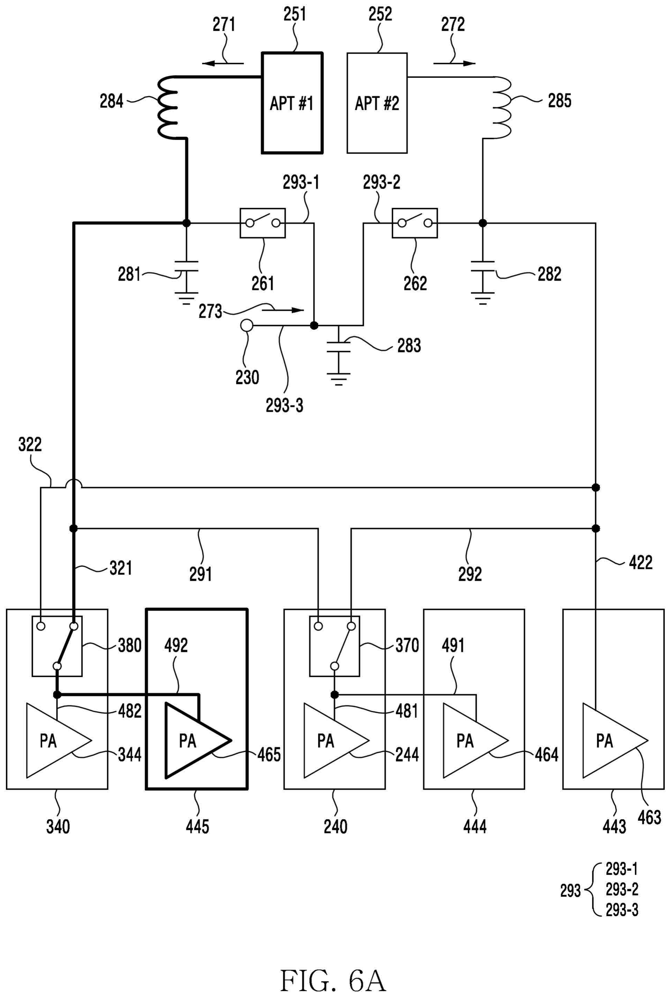

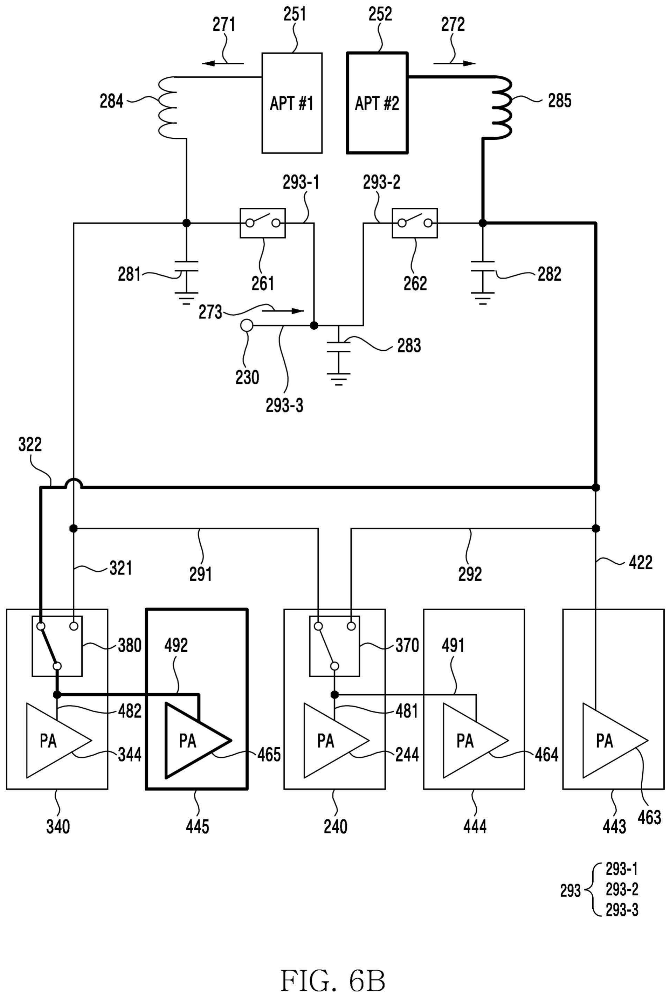

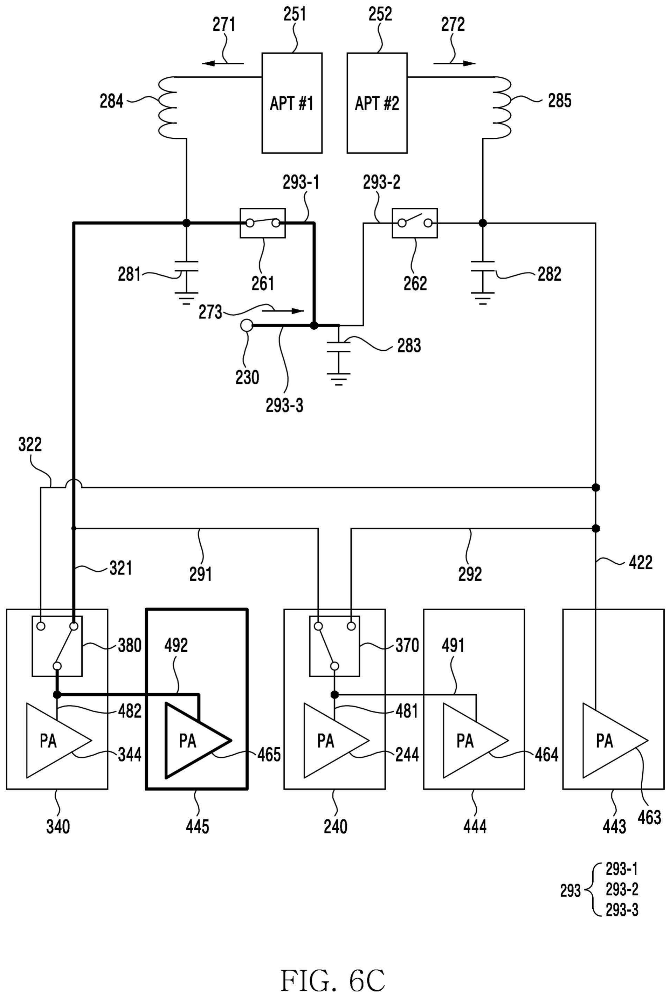

FIGS. 6A, 6B, and 6C indicates an example of a change in a supply voltage for a RFFE module. The electronic device 101 may include a processor 210, an RF transceiver 220, RFFE modules (e.g., a first RFFE module 240, a second RFFE module 340, a third RFFE module 443, a fourth RFFE module 444, a fifth RFFE module 445, and a power supply circuitry 250. For each component, the descriptions of FIGS. 2, 3, 4A, and 4B may be referred to.

Referring to FIG. 6A, the electronic device 101 may transmit a signal through the fifth RFFE module 445. The electronic device 101 may transmit a signal through a fifth PA 465 on a frequency band (e.g., a MB greater than or equal to about 1 GHz and less than 2.3 GHz, or HB greater than or equal to about 2.3 GHz and less than 3.4 GHz) supported in the fifth RFFE module 445. A first switching circuitry 261 may be in an open state. A first power supply circuitry 251 may generate a first supply voltage 271 based on APT. The first supply voltage 271 according to the APT may be provided to the fifth PA 465 of the fifth RFFE module 445 through a fourth power path 321. In providing the first supply voltage 271, a change of a power source may be required as the first power supply circuitry 251 is damaged and difficult to use, a current tolerance is exceeded, a problem by audible noise, and/or noise in a specific frequency band occur.

Referring to FIG. 6B, a fourth switching circuitry 380 may operate according to a control of the processor 210 and/or the RF transceiver 220 of an electronic device 101. For example, in case that a fourth switching circuitry 380 electrically connects a fifth power path 322 and the fifth RFFE module 445, the fifth PA 465 may obtain a second supply voltage (V_{cc2}) through the fifth power path 322 and a second subsequent power path 492.

Referring to FIG. 6C, a first switching circuitry 261 may operate according to the control of the processor 210 and/or the RF transceiver 220 of an electronic device 101. A state of the first switching circuitry 261 may change from the open state to the closed state. The first switching circuitry 261 may electrically connect the fourth power path 321 (e.g., including at least a portion of the first power path 291) and a third power path 293. Since the fourth power path 321 is connected to the third power path 293, a third supply voltage 273 of the third power source 230 may be provided to a fifth PA 465 of the fifth RFFE module 445.

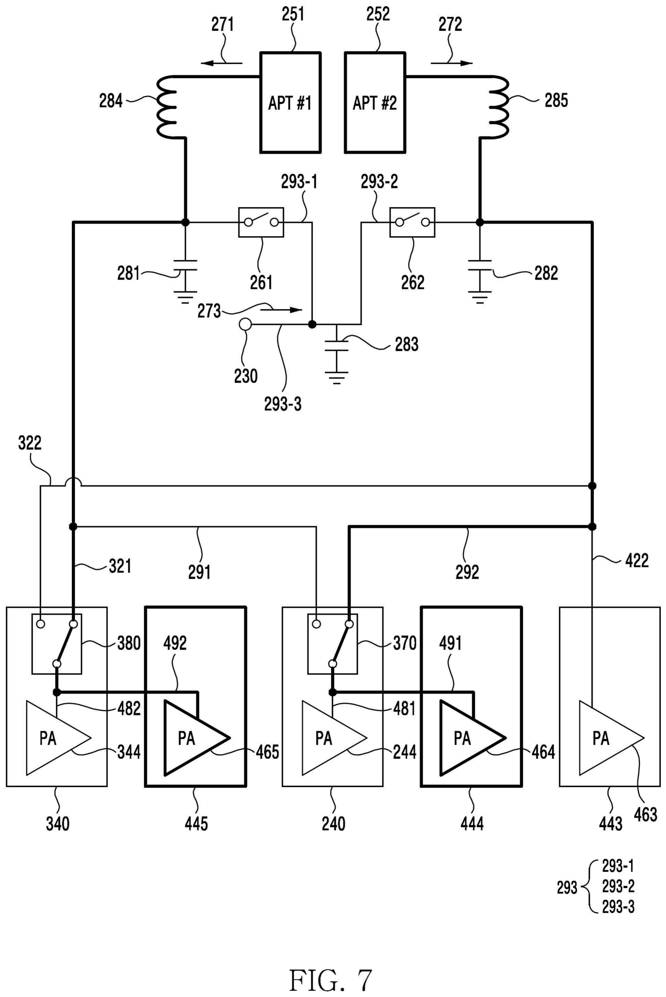

FIGS. 7, 8, and 9 illustrate an examples of a change in a supply voltage for RFFE modules in dual connectivity (DC). An electronic device 101 may include a processor 210, an RF transceiver 220, RFFE modules (e.g., a first RFFE module 240, a second RFFE module 340, a third RFFE module 443, a fourth RFFE module 444, a fifth RFFE module 445, and a power supply circuitry 250. For each component, the descriptions of FIGS. 2, 3, 4A, and 4B may be referred to.

Referring to FIG. 7, the electronic device 101 may transmit a signal through a plurality of RFFE modules in a DC situation. For example, the electronic device 101 may transmit a signal through the fourth RFFE module 444 and the fifth RFFE module 445. The electronic device 101 may transmit a signal through a fourth PA 464 on a frequency band (e.g., a MB of greater than or equal to about 1 GHz and less than 2.3 GHz, or a HB of greater than or equal to about 2.3 GHz and less than 3.4 GHz) supported in the fourth RFFE module 444. The electronic device 101 may transmit a signal through a fifth PA 465 on the frequency band (e.g., the MB of greater than or equal to about 1 GHz and less than 2.3 GHz, or the HB of greater than or equal to about 2.3 GHz and less than 3.4 GHz) supported in the fifth RFFE module 445. A first switching circuitry 261 and a second switching circuitry 262 may be in an open state. A first power supply circuitry 251 may generate a first supply voltage 271 based on APT. The first supply voltage 271 according to the APT may be provided to the fifth PA 465 of the fifth RFFE module 445 through a fourth power path 321 and a second subsequent power path 492. A second power supply circuitry 252 may generate a second supply voltage 272 based on the APT. The second supply voltage 272 according to the APT may be provided to the fourth PA 464 of the fourth RFFE module 444 through a second power path 292 and a first subsequent power path 491.

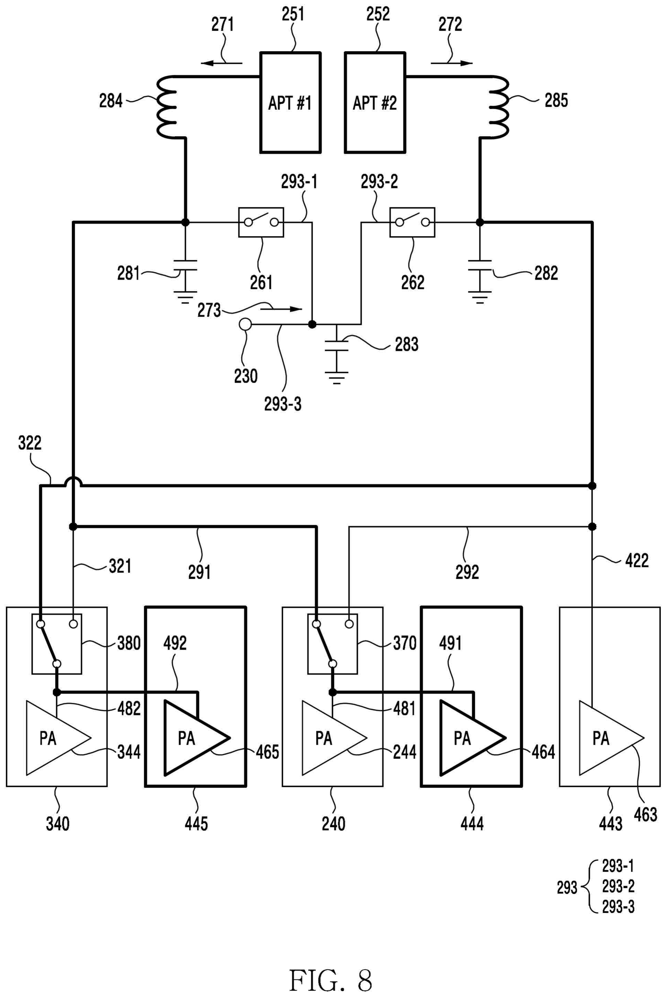

Referring to FIG. 8, paths through which a supply voltage is provided may be changed according to an operation of a third switching circuitry 370 and a fourth switching circuitry 380. For example, unlike FIG. 7, the third switching circuitry 370 may electrically connect a first power path 291 and the first subsequent power path 491. Unlike FIG. 7, the fourth switching circuitry 380 may electrically connect a fifth power path 322 and the second subsequent power path 492. The first power supply circuitry 251 may generate the first supply voltage 271 based on the APT. The first supply voltage 271 according to the APT may be provided to the fourth PA 464 of the fourth RFFE module 444 through the first power path 291 and the first subsequent power path 491. The second power supply circuitry 252 may generate the second supply voltage 272 based on the APT. The second supply voltage 272 according to the APT may be provided to the fifth PA 465 of the fifth RFFE module 445 through the fifth power path 322 and the second subsequent power path 492. A change of a power source may be required as the first power supply circuitry 251 and/or the second power supply circuitry 252 is damaged and difficult to use, a current tolerance is exceeded in each power supply circuitry, a problem by audible noise, and/or noise in a specific frequency band occur.

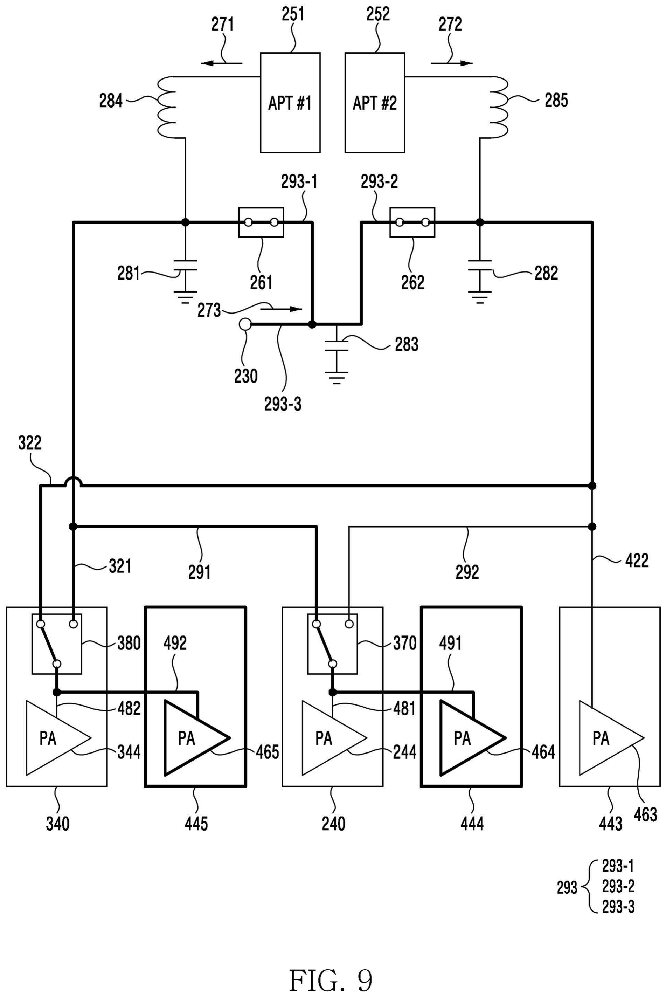

Referring to FIG. 9, the first switching circuitry 261 may operate according to the control of the processor 210 and/or the RF transceiver 220 of the electronic device 101. The state of the first switching circuitry 261 may change from the open state to the closed state. The second switching circuitry 262 may operate according to the control of the processor 210 and/or the RF transceiver 220 of the electronic device 101. The state of the second switching circuitry 262 may change from the open state to the closed state. The first switching circuitry 261 may electrically connect the first power path 291 and the third power path 293. Since the first power path 291 is connected to the third power path 293, a third supply voltage 273 of a third power source 230 may be provided to the fourth PA 464 of the fourth RFFE module 444 through the first power path 291, the third switching circuitry 370, and the first subsequent power path 491. The second switching circuitry 262 may electrically connect the fifth power path 322 (at least a portion of a second power path 292) and the third power path 293. Since the fifth power path 322 and the third power path 293 are connected, the third supply voltage 273 of the third power source 230 may be provided to the fifth PA 465 of the fifth RFFE module 445 through the fifth power path 322, the fourth switching circuitry 380, and the second subsequent power path 492.

In FIG. 9, an example in which the third supply voltage 273 of the third power source 230 is provided based on the state of the third switching circuitry 370 and the fourth switching circuitry 380 of FIG. 8 is described, but embodiments of the present disclosure are not limited thereto. As the first switching circuitry 261 and the second switching circuitry 262 are closed even in the circuitry state of FIG. 7 (i.e. state of the third switching circuitry 370 and the fourth switching circuitry 380 in FIG. 7), the third supply voltage 273 of the third power source 230 may be provided to the fourth PA 464 and the fifth PA 465, respectively. The third supply voltage 273 of the third power source 230 may be provided to the fourth PA 464 of the fourth RFFE module 444 through the second power path 292, the third switching circuitry 370, and the first subsequent power path 491. The third supply voltage 273 of the third power source 230 may be provided to the fifth PA 465 of the fifth RFFE module 445 through the fourth power path 321, the fourth switching circuitry 380, and the second subsequent power path 492.

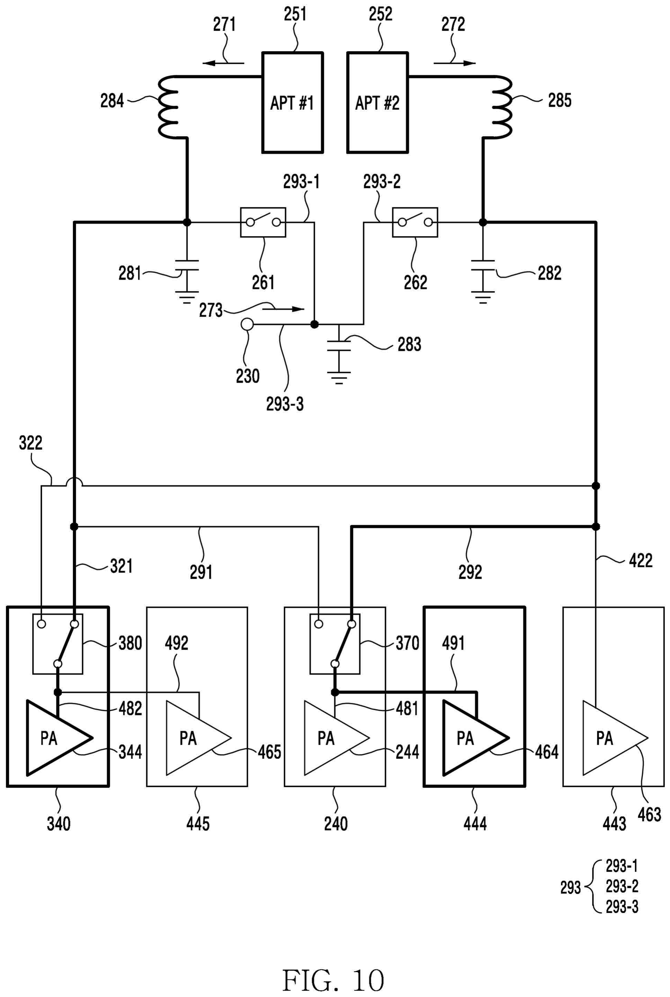

FIGS. 10, 11, and 12 indicate an example of a change in a supply voltage for RFFE modules in DC. An electronic device 101 may include a processor 210, an RF transceiver 220, RFFE modules (e.g., a first RFFE module 240, a second RFFE module 340, a third RFFE module 443, a fourth RFFE module 444, and a fifth RFFE module 445, a power supply circuitry 250, and an antenna 299. For each component, the descriptions of FIGS. 2, 3, 4A, and 4B may be referred to.

Referring to FIG. 10, the electronic device 101 may transmit a signal through a plurality of RFFE modules in a DC situation. For example, the electronic device 101 may transmit a signal through the second RFFE module 340 and the fourth RFFE module 444. The electronic device 101 may transmit a signal through a second PA 344 on a frequency band (e.g., UHB of greater than or equal to about 3.4 GHz) supported in the fifth RFFE module 445. The electronic device 101 may transmit a signal through a fourth PA 464 on a frequency band (e.g., a MB of greater than or equal to about 1 GHz and less than 2.3 GHz, or a HB of greater than or equal to about 2.3 GHz and less than 3.4 GHz). A first switching circuitry 261 and a second switching circuitry 262 may be in an open state. A first power supply circuitry 251 may generate a first supply voltage 271 based on APT. The first supply voltage 271 based on the APT may be provided to the second PA 344 of the second RFFE module 340 through a fourth power path 321. The second power supply circuitry 252 may generate a second supply voltage 272 based on the APT. The second supply voltage 272 according to the APT may be provided to the fourth PA 464 of the fourth RFFE module 444 through a second power path 292 and a first subsequent power path 491.

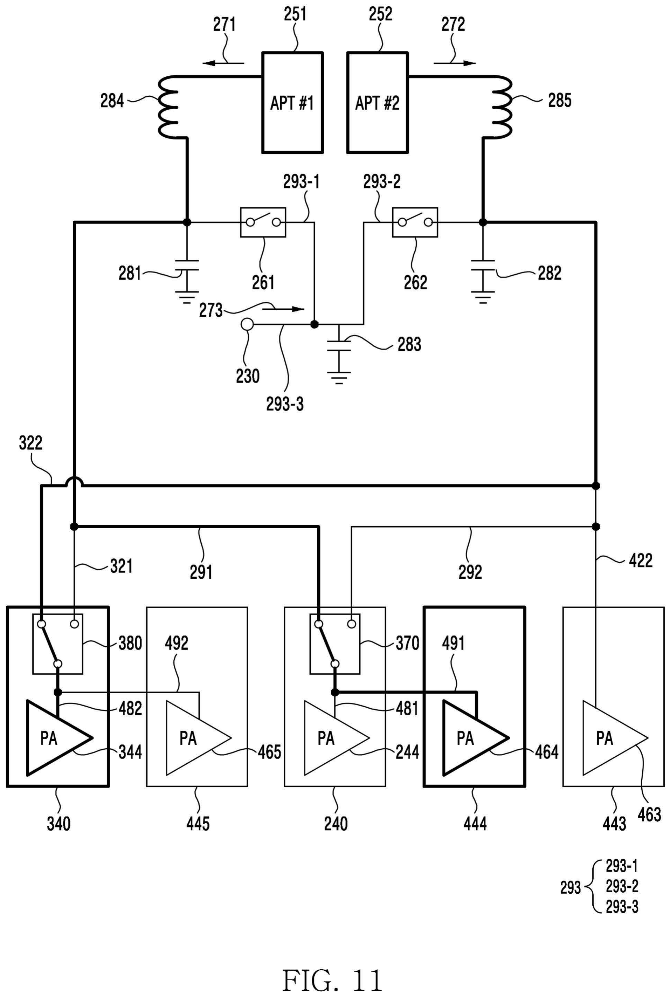

Referring to FIG. 11, paths through which a supply voltage is provided may be changed according to an operation of a third switching circuitry 370 and a fourth switching circuitry 380. For example, unlike FIG. 10, the third switching circuitry 370 may electrically connect a first power path 291 to the first subsequent power path 491. Unlike FIG. 10, a fourth switching circuitry 380 may electrically connect a fifth power path 322 to a second PA path 482. The first power supply circuitry 251 may generate the first supply voltage 271 based on the APT. The first supply voltage 271 according to the APT may be provided to the fourth PA 464 of the fourth RFFE module 444 through the first power path 291 and the first subsequent power path 491. The second power supply circuitry 252 may generate the second supply voltage 272 based on APT. The second supply voltage 272 according to the APT may be provided to the second PA 344 of the second RFFE module 340 through the fifth power path 322 and the second PA path 482. A change of a power source may be required as the first power supply circuitry 251 and/or the second power supply circuitry 252 is damaged and difficult to use, a current tolerance is exceeded in each power supply circuitry, a problem by audible noise, and/or noise in a specific frequency band occur.

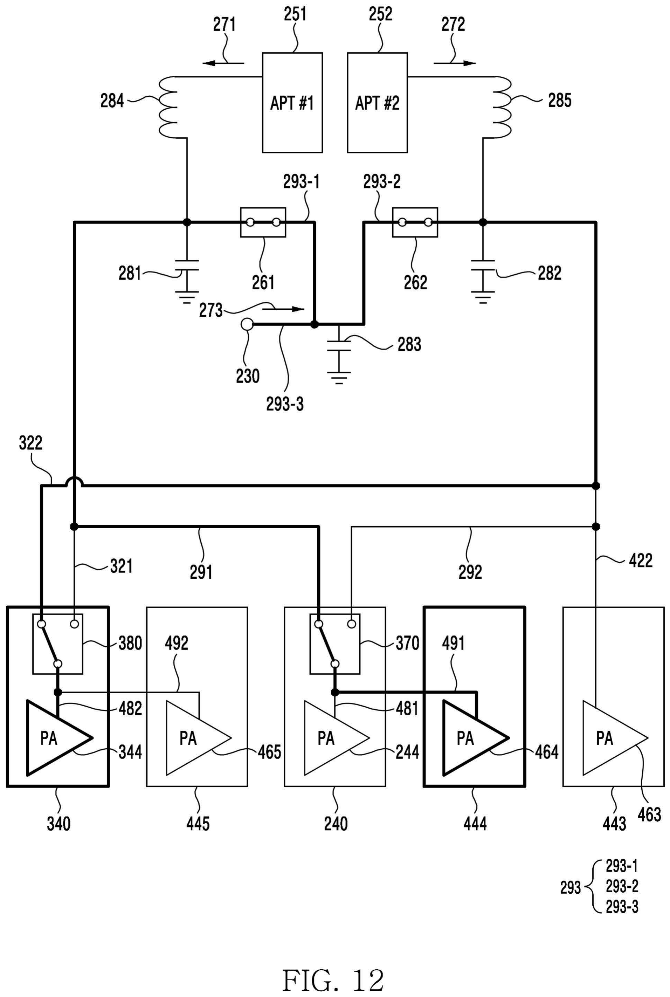

Referring to FIG. 12, the first switching circuitry 261 may operate according to a control of the processor 210 and/or the RF transceiver 220 of the electronic device 101. A state of the first switching circuitry 261 may change from the open state to a closed state. The second switching circuitry 262 may operate according to the control of the processor 210 and/or the RF transceiver 220 of the electronic device 101. A state of the second switching circuitry 262 may change from the open state to the closed state. The first switching circuitry 261 may electrically connect the first power path 291 and a third power path 293. Since the first power path 291 is connected to the third power path 293, a third supply voltage 273 of a third power source 230 may be provided to the fourth PA 464 of the fourth RFFE module 444 through the first power path 291, the third switching circuitry 370, and the first subsequent power path 491. The second switching circuitry 262 may electrically connect the fifth power path 322 (at least a portion of a second power path 292) and the third power path 293. Since the fifth power path 322 and the third power path 293 are connected, the third supply voltage 273 of the third power source 230 may be provided to the second PA 344 of the second RFFE module 340 through the fifth power path 322, the fourth switching circuitry 380, and the second PA path 482.

In FIG. 12, an example in which the third supply voltage 273 of the third power source 230 is provided based on the state of the third switching circuitry 370 and fourth switching circuitry 380 in FIG. 11 is described, but embodiments of the present disclosure are not limited thereto. As the first switching circuitry 261 and the second switching circuitry 262 are closed even in the circuitry state of FIG. 10, the third supply voltage 273 of the third power source 230 may be provided to the fourth PA 464 and a fifth PA 465, respectively. The third supply voltage 273 of the third power source 230 may be provided to the fourth PA 464 of the fourth RFFE module 444 through the second power path 292, the third switching circuitry 370, and the first subsequent power path 491. The third supply voltage 273 of the third power source 230 may be provided to the second PA 344 of the second RFFE module 340 through the fourth power path 321, the fourth switching circuitry 380, and the second PA path 482.

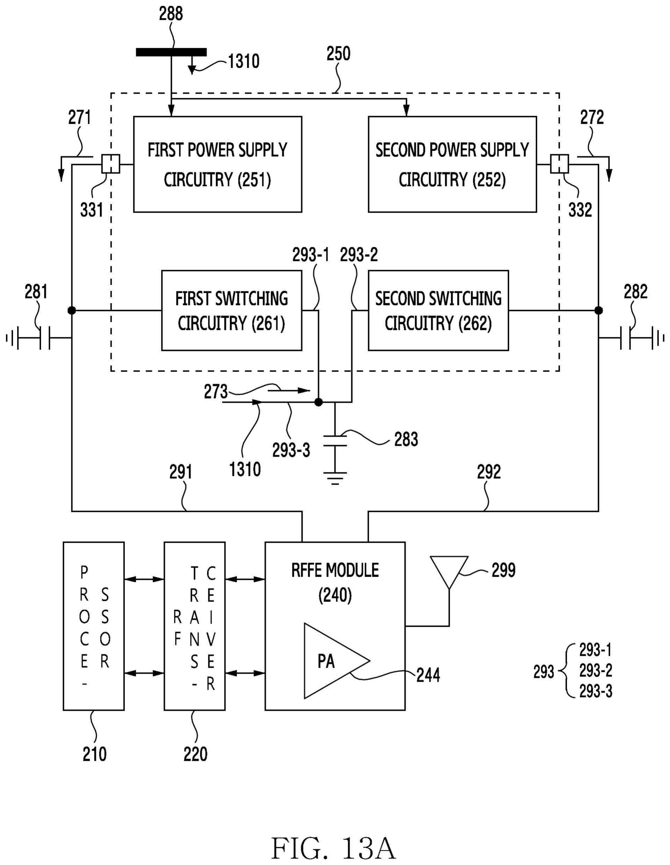

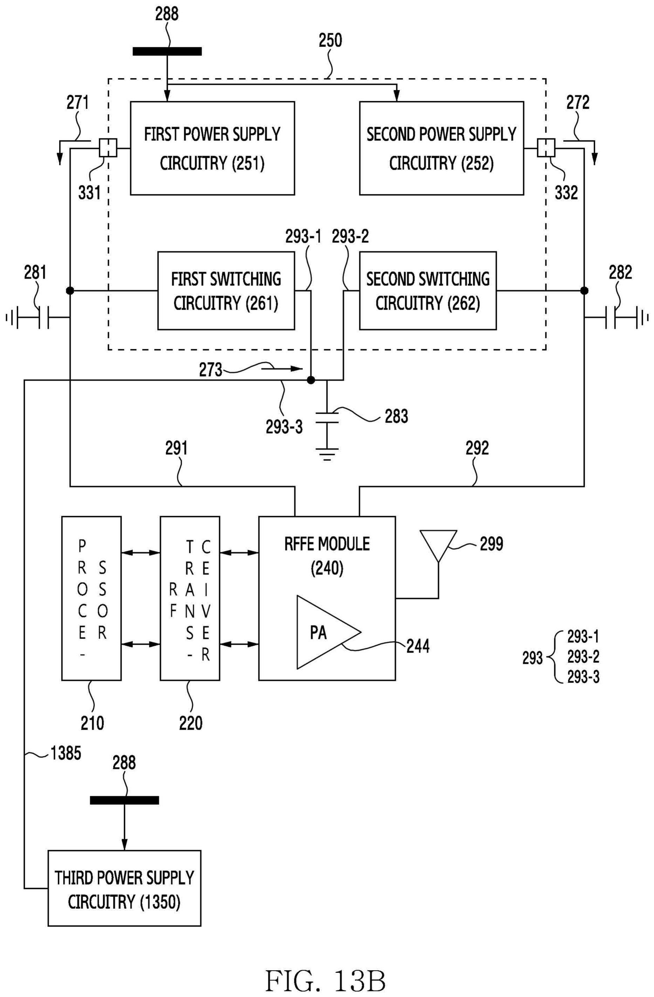

FIGS. 13A and 13B indicate examples of a third power source (e.g., a third power source 230).

Referring to FIG. 13A, an electronic device 101 may include a processor 210, an RF transceiver 220, an RFFE module 240, a power supply circuitry 250, a battery 288, and an antenna 299. For each component, the descriptions of FIG. 2 may be referred to. A voltage 1310 (hereinafter, a battery voltage (V_{bat})) of the battery 288 may be provided to each power supply circuitry (e.g., a first power supply circuitry 251 or a second power supply circuitry 252) of the power supply circuitry 250. The first power supply circuitry 251 may generate a first supply voltage 271 according to APT, based on the battery voltage 1310. The second power supply circuitry 252 may generate a second supply voltage 272 according to the APT, based on the battery voltage 1310. Since the third power source 230 is a power source used in case that a stable operation of the first power supply circuitry 251 and/or the second power supply circuitry 252 is difficult (e.g., excess of an allowable current, and generation of damage or audible noise), the battery 288 may be used as the third power source 230. According to an embodiment, the third power source 230 may correspond to the battery 288. A third supply voltage 273 may correspond to the battery voltage 1310. The battery 288 may be electrically connected to a third power path 293.

Referring to FIG. 13B, the electronic device 101 may include the processor 210, the RF transceiver 220, the RFFE module 240, the power supply circuitry 250, and the antenna 299. For each component, the descriptions of FIG. 2 may be referred to. The electronic device 101 may include a separate power supply circuitry (e.g., a third power supply circuitry 1350 (e.g., PMIC)) in addition to the power supply circuitry 250. The third power supply circuitry 1350 may generate a supply voltage based on a voltage 1310 (i.e., a battery voltage (V_{bat})) of the battery 288. The third power supply circuitry 1350 may provide a supply voltage to a RFFE module (e.g., a RFFE module 240 or a separate RFFE module). The third power supply circuitry 1350 may be connected to a third power path 293 and provide a supply voltage, such as to provide the supply voltage to the RFFE module. According to an embodiment, the third power source 230 may correspond to the third power supply circuitry 1350. A third supply voltage 273 may correspond to a supply voltage from the third power supply circuitry 1350. The third power supply circuitry 1350 may be electrically connected to the third power path 293 through a path 1385. As an example, while a power amplifier of the RFFE module connected to the third power supply circuitry 1350 is inactivated, the supply voltage of the third power supply circuitry 1350 may be provided to another RFFE module (e.g., the RFFE module 240) through the path 1385 and the third power path 293. In other words, the supply voltage (e.g., the third supply voltage 273) may be provided to a PA 244 of the RFFE module 240 through the third power path 293.

In embodiments, the electronic device 101 is provided. The electronic device 101 may comprise a processor 210 comprising a processing circuitry, a radio frequency (RF) transceiver 220, a first power supply circuitry 251 for providing a power amplifier with a first supply voltage 271, a second power supply circuitry 252 for providing the power amplifier or another power amplifier with a second supply voltage 272, a first power path 291 connected to the first power supply circuitry 251, a second power path 292 connected to the second power supply circuitry 252, a third power path 293, wherein a third supply voltage 273 is provided through the third power path, a first switching circuitry 261 configured to connect or not connect the third power path 293 to the first power path 291, a second switching circuitry 262 configured to connect or not connect the third power path 293 to the second power path 292, and a radio frequency front end (RFFE) module, including the power amplifier, connected to the first power path 291 and the second power path 292. The first switching circuitry 261 may be controlled to connect the first power path 291 and the third power path 293 while the first supply voltage 271 is not provided to the power amplifier through the first power path 291 through the first power path. The second switching circuitry 262 may be controlled to connect the second power path 292 and the third power path 293 while the second supply voltage 272 is not provided to the power amplifier through the second power path.

For example, the first switching circuitry 261 may be configured to connect the first power path 291 and the third power path 293, to provide the power amplifier with the third supply voltage 273 instead of the first supply voltage 271 from the first power supply circuitry 251. The second switching circuitry 262 may be configured to connect the second power path 292 and the third power path 293, to provide the power amplifier with the third supply voltage 273 instead of the second supply voltage 272 from the second power supply circuitry 252.

For example, the first switching circuitry 261 may be controlled to not connect the first power path 291 and the third power path 293 while the first supply voltage 271 is provided to the power amplifier through the first power path 291. The second switching circuitry 262 may be controlled to not connect the second power path 292 and the third power path 293 while the second supply voltage 272 is provided to the power amplifier through the second power path 292.

For example, the electronic device 101 may include a third power supply circuitry to provide the third supply voltage 273. The third power path 293 may be electrically connected to the third power supply circuitry.

For example, the third supply voltage 273 may be provided from a battery of the electronic device 101.

For example, the RFFE module may include a third switching circuitry. The third switching circuitry may be configured to connect the power amplifier to the first power path 291 or the second power path 292, selectively.

For example, the electronic device 101 may comprise a fourth power path branching from a node of the first power path 291, a fifth power path branching from a node of the second power path 292, and a second RFFE module, including a second power amplifier, connected to the fourth power path and the fifth power path. The second RFFE module may include a fourth switching circuitry for connecting the second power amplifier to the fourth power path or the fifth power path, selectively.

For example, the electronic device may include a second RFFE module including a second power amplifier and a fourth switching circuit; a fourth power path connecting from a node of the first power path to the second RFFE module; and a fifth power path connecting from a node of the second power path to the second RFFE module. The fourth switching circuit may be configured to selectively connect the fourth power path or the fifth power path to the second power amplifier.

For example, the electronic device 101 may further include a sixth power path branching from the second power path 292, and a third RFFE module, including a third power amplifier, connected to the sixth power path. The second switching circuitry 262 may be controlled to not connect the second power path 292 and the third power path 293, while the second supply voltage 272 is provided to the third power amplifier through the sixth power path, and connect the second power path 292 and the third power path 293, while the second supply voltage 272 is not provided to the third power amplifier through the sixth power path.

For example, the electronic device may include a third RFFE module including a third power amplifier; and a sixth power path connected from a node of the second power path to the third RFFE module. The second switching circuit may be controlled to not connect the second power path and the third power path while the second supply voltage is provided to the third power amplifier via the sixth power path, and may be controlled to connect the second power path and the third power path while the second supply voltage is not provided to the third power amplifier via the sixth power path.

For example, the electronic device 101 may comprise a first subsequent power path connected to the first power path 291 or the second power path 292 through the third switching circuitry, and a fourth RFFE module including a fourth power amplifier connected to the first subsequent power path. The first switching circuitry 261 may be controlled to not connect the first power path 291 and the third power path 293, while the first supply voltage 271 is provided to the fourth power amplifier through the first subsequent power path, and connect the first power path 291 and the third power path 293, while the first supply voltage 271 is not provided to the fourth power amplifier through the first subsequent power path.

For example, the electronic device 101 may comprise a second subsequent power path connected to the fourth power path or the fifth power path through the fourth switching circuitry, and a fifth RFFE module including a fifth power amplifier connected to the second subsequent power path.

For example, while the first supply voltage 271 is provided to the fourth RFFE module through the first power supply circuitry 251 and the second supply voltage 272 is provided to the fifth RFFE module through the second power supply circuitry 252, the first switching circuitry 261 may be opened and the second switching circuitry 262 may be opened. While the first supply voltage 271 is not provided to the fourth RFFE module through the first power supply circuitry 251 and the second supply voltage 272 is not provided to the fifth RFFE module through the second power supply circuitry 252, the first switching circuitry 261 may be controlled to connect the first power path 291 to the third power path 293 and the second switching circuitry 262 may be controlled to connect the second power path 292 and the third power path 293.

For example, while the first supply voltage 271 is provided to the second RFFE module through the first power supply circuitry 251 and the second supply voltage 272 is provided to the fifth RFFE module through the second power supply circuitry 252, the first switching circuitry 261 may be opened and the second switching circuitry 262 may be opened. While the first supply voltage 271 is not provided to the second RFFE module through the first power supply circuitry 251 and the second supply voltage 272 is not provided to the fifth RFFE module through the second power supply circuitry 252, the first switching circuitry 261 may be controlled to connect the first power path 291 to the third power path 293 and the second switching circuitry 262 may be controlled to connect the second power path 292 to the third power path 293.

For example, each of the first RFFE module and the second RFFE module may be configured to process signals in a frequency band of a first frequency range. The third RFFE module may be configured to process signals in a frequency band of a second frequency range lower than the first frequency range. The fourth RFFE module may be configured to process signals in the frequency band for EUTRA-NR (EN)- dual connectivity (DC). The fifth RFFE module may be configured to process signals in a frequency band of a third frequency range lower than the first frequency range and higher than the second frequency range.

For example, the first frequency range may include frequency bands greater than or equal to about 3.4 GHz. The second frequency range may include frequency bands below about 1 GHz.

For example, the fourth switching circuitry may be controlled to connect the fifth power path to the second power amplifier while the third switching circuitry connects the fourth power path to the power amplifier. The fourth switching circuitry may be controlled to connect the fourth power path to the second power amplifier while the third switching circuitry connects the fifth power path to the power amplifier.

For example, the electronic device 101 may comprise a first capacitor connected to the first power path 291 and a second capacitor connected to the second power path 292. The first power supply circuitry 251 may be configured to provide the first supply voltage 271 based on average power tracking (APT). The second power supply circuitry 252 may be configured to provide the second supply voltage 272 based on APT.

For example, the electronic device 101 may comprise an average power tracking (APT) capacitor electrically connected to the third power path 293. The first power supply circuitry 251 and the second power supply circuitry 252 may be included in a power supply module.

For example, the power supply module may include a first capacitor port electrically connected to the first switching circuitry 261 and a second capacitor port electrically connected to the second switching circuitry 262. Each of the first capacitor port and the second capacitor port may be connected to the third power path 293. Each of the first capacitor port and the second capacitor port may be connected to the APT capacitor.

In embodiments, a power supply module is provided. A power supply module may comprise a first output port, a second output port, a third output port, a fourth output port, a first capacitor port, a second capacitor port, a first power supply circuitry 251 for providing a first supply voltage 271, connected to the first output port, a second power supply circuitry 252 for providing a second supply voltage 272, connected to the second output port, a first switching circuitry 261 configured to connect or not connect the third output port to the first capacitor port, and a second switching circuitry 262 configured to connect or not connect the fourth output port to the second capacitor port. The first switching circuitry 261 may be controlled to connect the third output port to the first capacitor port while the first supply voltage 271 is not provided through the first output port. The second switching circuitry 262 may be controlled to connect the fourth output port to the second capacitor port while the second supply voltage 272 is not provided through the second output port.

For example, the first switching circuitry 261 may be controlled to not connect the third output port to the first capacitor port while the first supply voltage 271 is provided through the first output port. The second switching circuitry 262 may be controlled to not connect the fourth output port to the second capacitor port while the second supply voltage 272 is provided through the second output port.

For example, the first power supply circuitry 251 may be configured to provide the first supply voltage 271 based on average power tracking (APT). The second power supply circuitry 252 may be configured to provide the second supply voltage 272 based on APT.

The electronic device 101 according to embodiments of the present disclosure may enable a normal operation of the electronic device 101 even if a problem occurs in the first power supply circuitry 251 and/or the second power supply circuitry 252 by connecting a separate power source (e.g., the third power source path 293) to a path (e.g., the third power source path 293) of the power supply circuitry 250.

The effects that may be obtained from the present disclosure are not limited to those described above, and any other effects not mentioned herein will be clearly understood by those having ordinary knowledge in the art to which the present disclosure belongs, from the following description.

In accordance with an exemplary embodiment, an electronic device comprises a first radio frequency front end (RFFE) module including a first power amplifier; a first power supply circuitry for providing the power amplifier with a first supply voltage through a first power path; a second power supply circuitry for providing the first power amplifier with a second supply voltage through a second power path; a third power path for providing a third supply voltage; a first switching circuitry configured to, when in a first state, connect the third power path to the first power path and, when in a second state, disconnect the third power path from the first power path; a second switching circuitry configured to, when in a first state, connect the third power path to the second power path and, when in a second state, disconnect the third power path from the second power path. The first switching circuitry is configured to connect the first power path to the third power path to provide the third supply voltage to the first power amplifier while the first supply voltage is not provided to the power amplifier through the first power path during operation of the first power amplifier. The second switching circuitry is configured to connect the second power path to the third power path to provide the third supply voltage to the first power amplifier while the second supply voltage is not provided to the power amplifier through the second power path during operation of the first power amplifier.

For example, the first switching circuitry is controllable to disconnect the first power path from the third power path while the first supply voltage is provided to the first power amplifier through the first power path during operation of the first power amplifier. The second switching circuitry is configured to disconnect the second power path from the third power path while the second supply voltage is provided to the first power amplifier through the second power path during operation of the first power amplifier.

For example, the third supply voltage is provided from a battery of the electronic device or provided from a third power supply circuitry different from the first power supply circuitry and the second power supply circuitry.

For example, the first RFFE module includes a third switching circuitry. The third switching circuitry is configured to, when in a first state, connect the first power amplifier to the first power path and, when in a second state, connect the first power amplifier in the second power path.

For example, the electronic device comprises a second RFFE module, including a second power amplifier and a fourth switching circuitry; a fourth power path connecting from a node of the first power path to the second RFFE module; and a fifth power path connecting from a node of the second power path to the second RFFE module. The fourth switching circuitry is configured to, when in a first state, connect the second power amplifier to the fourth power path and, when in a second state, connect the second power amplifier to the fifth power path.

For example, the electronic device comprises a third RFFE module, including a third power amplifier; and a sixth power path connecting from a node of the second power path to the third RFFE module. The second switching circuitry is configured to disconnect the second power path from the third power path, while the second supply voltage is provided to the third power amplifier through the sixth power path, and connect the second power path to the third power path, while the second supply voltage is not provided to the third power amplifier through the sixth power path during operation of the third power amplifier.

For example, the electronic device comprises a first subsequent power path connected to the first power path or the second power path through the third switching circuitry; and a fourth RFFE module including a fourth power amplifier connected to the first subsequent power path. The first switching circuitry is configured to disconnect the first power path and the third power path, while the first supply voltage is provided to the fourth power amplifier through the first subsequent power path, and connect the first power path and the third power path, while the first supply voltage is not provided to the fourth power amplifier through the first subsequent power path during operation of the fourth power amplifier.

For example, the electronic device comprises a second subsequent power path connected to the fourth power path or the fifth power path through the fourth switching circuitry; and a fifth RFFE module including a fifth power amplifier connected to the second subsequent power path.

For example, while the first supply voltage is provided to the fourth RFFE module and the second supply voltage is provided to the fifth RFFE module, the first switching circuitry is configured to disconnect the first power path from the third power path and the second switching circuitry is configured to disconnect the second power path from the third power path. While the first supply voltage is not provided to the fourth RFFE module during operation of the fourth power amplifier and the second supply voltage is not provided to the fifth RFFE module during operation of the fifth power amplifier, the first switching circuitry is configured to connect the first power path and the third power path and the second switching circuitry is configured to connect the second power path and the third power path.

For example, while the first supply voltage is provided to the second RFFE module and the second supply voltage is provided to the fifth RFFE module, the first switching circuitry is configured to disconnect the first power path from the third power path and the second switching circuitry is configured to disconnect the second power path from the third power path. While the first supply voltage is not provided to the second RFFE module during operation of the second power amplifier and the second supply voltage is not provided to the fifth RFFE module during operation of the fifth power amplifier, the first switching circuitry is configured to connect the first power path and the third power path and the second switching circuitry is configured to connect the second power path and the third power path.

For example, each of the first RFFE module and the second RFFE module is configured to process signals in a frequency band of a first frequency range. The third RFFE module is configured to process signals in a frequency band of a second frequency range lower than the first frequency range. The fourth RFFE module is configured to process signals in the frequency band for evolved universal terrestrial radio access (E-UTRA)-new radio (NR) (EN)-dual connectivity (DC). The fifth RFFE module is configured to process signals in a frequency band of a third frequency range lower than the first frequency range and higher than the second frequency range.

For example, the first frequency range includes frequency bands greater than or equal to approximately3.4 GHz. The second frequency range includes frequency bands below approximately1 GHz.

For example, the fourth switching circuitry is configured to connect the fifth power path to the second power amplifier while the third switching circuitry connects the fourth power path to the power amplifier, and connect the fourth power path to the second power amplifier while the third switching circuitry connects the fifth power path to the power amplifier.

For example, a first capacitor connected to the first power path; and a second capacitor connected to the second power path. The first power supply circuitry is configured to provide the first supply voltage based on average power tracking (APT). The second power supply circuitry is configured to provide the second supply voltage based on APT.

For example, the electronic device comprises an average power tracking (APT) capacitor electrically connected to the third power path. The first power supply circuitry and the second power supply circuitry are included in a power supply module.

For example, the power supply module includes a first capacitor port electrically connected to the first switching circuitry and a second capacitor port electrically connected to the second switching circuitry. Each of the first capacitor port and the second capacitor port is connected to the third power path. Each of the first capacitor port and the second capacitor port is connected to the APT capacitor.

In accordance with an exemplary embodiment a power supply module comprises a first output port; a second output port; a third output port; a fourth output port; a first capacitor port; a second capacitor port; a first power supply circuitry for providing a first supply voltage, connected to the first output port; a second power supply circuitry for providing a second supply voltage, connected to the second output port; a first switching circuitry configured to, when in a first state, connect the third output port to the first capacitor port and, when in a second state, disconnect the third output power from the first capacitor port; and a second switching circuitry configured to, when in a first state, connect the fourth output port to the second capacitor port and, when in a second state, disconnect the fourth output port from the second capacitor port. The first switching circuitry is configured to connect the third output port to the first capacitor port while the first supply voltage is not provided through the first output port. The second switching circuitry is configured to connect the fourth output port to the second capacitor port while the second supply voltage is not provided through the second output port.

For example, the first switching circuitry is configured to disconnect the third output port from the first capacitor port while the first supply voltage is provided through the first output port. The second switching circuitry is configured to disconnect the fourth output port from the second capacitor port while the second supply voltage is provided through the second output port.

For example, the first power supply circuitry is configured to provide the first supply voltage based on average power tracking (APT). The second power supply circuitry is configured to provide the second supply voltage based on APT.

For one or more embodiments, at least one of the components described in one or more of the preceding drawings may be configured to perform one or more of the operations, techniques, processes, and/or methods described in the present disclosure. For example, a processor (e.g., a baseband processor) described in the present disclosure with respect to one or more of the preceding drawings may be configured to operate according to one or more of the examples described in the present disclosure. For another example, circuitry associated with a user equipment (UE), a base station, a network element, etc., as described above with respect to one or more of the preceding drawings may be configured to operate according to one or more of the examples described herein.

Any of the embodiments described above may be combined with any other embodiment (or combination of embodiments) unless expressly stated otherwise. The foregoing description of one or more implementations provides examples and descriptions, but is not intended to be exhaustive or to limit the scope of the embodiments to the precise forms disclosed. Modifications and variations are possible in light of the above teachings or may be obtained from practicing various embodiments.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In accordance with an example of the present disclosure, there is provided an electronic device comprising: a radio frequency front end (RFFE) module comprising a power amplifier; a first power supply configured to provide a first supply voltage to the RFFE module; a second power supply configured to provide a second supply voltage to the RFFE module; a third power supply configured to provide a third supply voltage; and switching circuitry configured to, when in a first state connect the third power supply to the RFFE module and, when in a second state disconnect the third power supply from the RFFE module, and wherein the switching circuitry is configured to be in the first state when at least one of the first supply voltage and the second supply voltage is not being provided to the RFFE module during operation of the power amplifier.

In an example, the first power supply, the second power supply, and at least a portion of the switching circuitry is included in a power supply module, and the third power supply is connected to the switching circuitry included in the power supply module.

## Claims

1. An electronic device comprising:
a processor comprising processing circuitry,
a radio frequency (RF) transceiver;
a first power supply circuitry for providing a power amplifier with a first supply voltage;
a second power supply circuitry for providing the power amplifier or another power amplifier with a second supply voltage;
a first power path connected to the first power supply circuitry;
a second power path connected to the second power supply circuitry;
a third power path, wherein a third supply voltage is provided through the third power path;
a first switching circuitry configured to connect or not connect the third power path to the first power path;
a second switching circuitry configured to connect or not connect the third power path to the second power path; and
a radio frequency front end (RFFE) module, including the power amplifier, connected to the first power path and the second power path,
wherein the first switching circuitry is controlled to connect the first power path to the third power path while the first supply voltage is not provided to the power amplifier through the first power path, and
wherein the second switching circuitry is controlled to connect the second power path to the third power path while the second supply voltage is not provided to the power amplifier through the second power path.

2. The electronic device of claim 1,
wherein the first switching circuitry is controlled to not connect the first power path to the third power path while the first supply voltage is provided to the power amplifier through the first power path, and
wherein the second switching circuitry is controlled to not connect the second power path to the third power path while the second supply voltage is provided to the power amplifier through the second power path.

3. The electronic device of claim 1,
wherein the first switching circuitry is configured to connect the first power path and the third power path, to provide the power amplifier with the third supply voltage instead of the first supply voltage from the first power supply circuitry.
wherein the second switching circuitry is configured to connect the second power path and the third power path, to provide the power amplifier with the third supply voltage instead of the second supply voltage from the second power supply circuitry.

4. The electronic device of claim 1, wherein the third supply voltage is provided from a battery of the electronic device or provided from a third power supply circuitry different from the first power supply circuitry and the second power supply circuitry.

5. The electronic device of claim 1, wherein the RFFE module includes a third switching circuitry,
wherein the third switching circuitry is configured to connect the power amplifier to the first power path or the second power path, selectively.

6. The electronic device of claim 5, further comprising:
a second RFFE module, including a second power amplifier and a fourth switching circuitry;
a fourth power path connecting from a node of the first power path to the second RFFE module;
a fifth power path connecting from a node of the second power path to the second RFFE module;
wherein the fourth switching circuitry is configured to connect the second power amplifier to the fourth power path or the fifth power path, selectively.

7. The electronic device of claim 6, further comprising:
a third RFFE module, including a third power amplifier; and
a sixth power path connecting from a node of the second power path to the third RFFE module,
wherein the second switching circuitry is configured to:
not connect the second power path and the third power path, while the second supply voltage is provided to the third power amplifier through the sixth power path, and
connect the second power path and the third power path, while the second supply voltage is not provided to the third power amplifier through the sixth power path.

8. The electronic device of claim 7, further comprising
a first subsequent power path connected to the first power path or the second power path through the third switching circuitry; and
a fourth RFFE module including a fourth power amplifier connected to the first subsequent power path,
wherein the first switching circuitry is controlled to:
not connect the first power path and the third power path, while the first supply voltage is provided to the fourth power amplifier through the first subsequent power path, and
connect the first power path and the third power path, while the first supply voltage is not provided to the fourth power amplifier through the first subsequent power path.

9. The electronic device of claim 8, further comprising
a second subsequent power path connected to the fourth power path or the fifth power path through the fourth switching circuitry; and
a fifth RFFE module including a fifth power amplifier connected to the second subsequent power path.

10. The electronic device of claim 9,
wherein, while the first supply voltage is provided to the fourth RFFE module through the first power supply circuitry and the second supply voltage is provided to the fifth RFFE module through the second power supply circuitry, the first switching circuitry is open and the second switching circuitry is open, and
wherein, while the first supply voltage is not provided to the fourth RFFE module through the first power supply circuitry and the second supply voltage is not provided to the fifth RFFE module through the second power supply circuitry, the first switching circuitry is controlled to connect the first power path and the third power path and the second switching circuitry is controlled to connect the second power path and the third power path.

11. The electronic device of claim 9,
wherein, while the first supply voltage is provided to the second RFFE module through the first power supply circuitry and the second supply voltage is provided to the fifth RFFE module through the second power supply circuitry, the first switching circuitry is open and the second switching circuitry is open, and
wherein, while the first supply voltage is not provided to the second RFFE module through the first power supply circuitry and the second supply voltage is not provided to the fifth RFFE module through the second power supply circuitry, the first switching circuitry is controlled to connect the first power path and the third power path and the second switching circuitry is controlled to connect the second power path and the third power path.

12. The electronic device of claim 9,
wherein each of the first RFFE module and the second RFFE module is configured to process signals in a frequency band of a first frequency range,
wherein the third RFFE module is configured to process signals in a frequency band of a second frequency range lower than the first frequency range,
wherein the fourth RFFE module is configured to process signals in the frequency band for evolved universal terrestrial radio access (E-UTRA)-new radio (NR) (EN)- dual connectivity (DC), and
wherein the fifth RFFE module is configured to process signals in a frequency band of a third frequency range lower than the first frequency range and higher than the second frequency range.

13. The electronic device of claim 12,
wherein the first frequency range includes frequency bands greater than or equal to approximately3.4 GHz, and
wherein the second frequency range includes frequency bands below approximately 1 GHz.

14. The electronic device of claim 6,
wherein the fourth switching circuitry is controlled to:
connect the fifth power path to the second power amplifier while the third switching circuitry connects the fourth power path to the power amplifier, and
connect the fourth power path to the second power amplifier while the third switching circuitry connects the fifth power path to the power amplifier.

15. The electronic device of claim 1, further comprising
a first capacitor connected to the first power path; and
a second capacitor connected to the second power path,
wherein the first power supply circuitry is configured to provide the first supply voltage based on average power tracking (APT), and
wherein the second power supply circuitry is configured to provide the second supply voltage based on APT.
